(19) Europäisches Patentamt
European Patent Office
Office européen des brevets

(11) EP 4 589 607 A1

(12) # EUROPEAN PATENT APPLICATION
published in accordance with Art. 153(4) EPC

(43) Date of publication:
**23.07.2025 Bulletin 2025/30**

(21) Application number: **23865429.7**

(22) Date of filing: **08.09.2023**

(51) International Patent Classification (IPC):
***H01B 1/22*** (2006.01) ***B22F 1/00*** (2022.01)
***B22F 1/052*** (2022.01) ***B22F 1/054*** (2022.01)
***B22F 1/065*** (2022.01) ***B22F 1/068*** (2022.01)
***B22F 1/102*** (2022.01) ***B22F 1/107*** (2022.01)
***B22F 7/08*** (2006.01) ***B82Y 30/00*** (2011.01)
***H01B 1/00*** (2006.01) ***H05K 3/32*** (2006.01)

(52) Cooperative Patent Classification (CPC):
**B22F 1/00; B22F 1/052; B22F 1/054; B22F 1/065; B22F 1/068; B22F 1/102; B22F 1/107; B22F 7/08; B82Y 30/00; H01B 1/00; H01B 1/22; H05K 3/32**

(86) International application number:
**PCT/JP2023/032896**

(87) International publication number:
**WO 2024/058074 (21.03.2024 Gazette 2024/12)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **14.09.2022 JP 2022146294**

(71) Applicant: **Daicel Corporation**
**Osaka-shi, Osaka 530-0011 (JP)**

(72) Inventors:
- **NAGAI, Rumi**
**Tokyo 108-8230 (JP)**
- **EGAWA, Tomoya**
**Tokyo 108-8230 (JP)**

(74) Representative: **Grünecker Patent- und Rechtsanwälte PartG mbB**
**Leopoldstraße 4**
**80802 München (DE)**

(54) **BONDING CONDUCTOR PASTE**

(57) An object of the present disclosure is to provide a bonding conductive paste capable of suppressing solvent bleeding to improve printing suitability, and of suppressing void generation to improve bondability. The bonding conductive paste of the present disclosure contains electrically conductive particles, a dispersion medium containing a hydroxy group-containing ether-based solvent, and a urea compound. A content of the urea compound relative to 100 parts by mass of the entire dispersion medium containing the hydroxy group-containing ether-based solvent is from 1 to 20 parts by mass, or a content of the urea compound relative to 100 parts by mass of the electrically conductive particles is from 0.1 to 2 parts by mass.

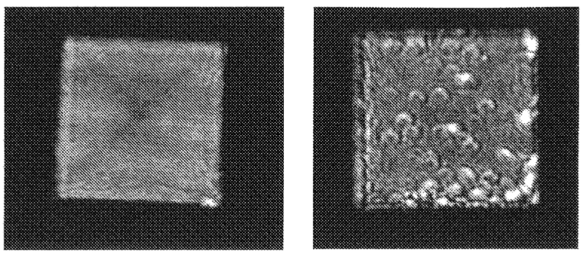
(a) (b)

FIG. 1

EP 4 589 607 A1

## Description

Technical Field

The present disclosure relates to a bonding conductive paste suitable for forming sintered bodies such as a conductive wire and a joint structure for connecting electronic elements. More specifically, the present disclosure relates to a bonding conductive paste suitable for use in forming a conductive wire or a joint structure for connecting electronic elements, such as a power semiconductor element and an LED element. The present application claims priority to JP 2022-146294 filed in Japan on September 14, 2022, the content of which is incorporated herein by reference.

Background Art

In mounting an electronic element such as a power semiconductor element or an LED element, a plurality of materials are required to be bonded to each other with high strength. For this purpose, a conductive wire, a joint structure, or a wiring board including them is used.

For example, a method for forming the conductive wire is known, in which a conductive paste containing electrically conductive particles and an organic solvent is applied onto an insulating substrate by a printing method, and then sintered to produce a conductive wire.

For example, Patent Document 1 discloses a bonding conductive paste containing electrically conductive particles and a specific ether-based solvent. Patent Document 1 describes that using the bonding conductive paste enables printing without unevenness and formation of a highly precise conductive wire or a joint structure capable of connecting a substrate and an electronic element with high bonding strength.

Citation List

Patent Document

Patent Document 1: JP 2020-194786 A

Summary of Invention

Technical Problem

Although the conductive paste containing an ether-based solvent has good wettability to a substrate, the conductive paste is likely to cause solvent bleeding and may cause a printing defect. In addition, in a large chip having an area of 10 mm square or more, the solvent does not volatilize sufficiently, which may cause void generation and poor bondability.

Thus, an object of the present disclosure is to provide a bonding conductive paste capable of reducing solvent bleeding to improve printing suitability and of reducing void generation to improve bondability.

Solution to Problem

As a result of diligent studies to solve the above problems, the inventors of the present disclosure have found that a bonding conductive paste containing electrically conductive particles, a hydroxy group-containing ether-based solvent, and a urea compound can suppress solvent bleeding to improve printing suitability, and can suppress void generation during sintered body formation to improve bondability. The present disclosure relates to those completed based on these findings.

Accordingly, the present disclosure relates to a bonding conductive paste containing electrically conductive particles, a dispersion medium containing a hydroxy group-containing ether-based solvent, and a urea compound, wherein

a content of the urea compound is from 1 to 20 parts by mass relative to 100 parts by mass of the entire dispersion medium containing the hydroxy group-containing ether-based solvent.

In addition, the present disclosure relates to a bonding conductive paste containing electrically conductive particles, a dispersion medium containing a hydroxy group-containing ether-based solvent, and a urea compound, wherein

a content of the urea compound is from 0.1 to 2 parts by mass relative to 100 parts by mass of the electrically conductive particles.

In the bonding conductive paste, the hydroxy group-containing ether-based solvent may contain a compound

represented by Formula (A) described below: $R^a$-O-($R^b$-O)$_n$-OH (A)
(wherein, $R^a$ represents an alkyl group, an aryl group, or an aralkyl group; $R^b$ represents an alkylene group having from 1 to 6 carbons; and n represents an integer of 1 or more).

In the bonding conductive paste, the urea compound may be at least one selected from the group consisting of a modified urea, a urea-modified urethane, a polymeric urea derivative, and a urea-modified polyamide.

In the bonding conductive paste, the electrically conductive particles may contain silver particles.

In the bonding conductive paste, the electrically conductive particles may contain electrically conductive nanoparticles (A) having an average particle size of 1 nm or more and less than 100 nm, and
the electrically conductive nanoparticles (A) may be electrically conductive nanoparticles each having a configuration in which a surface is coated with a protective agent containing an amine.

In the bonding conductive paste, a proportion of the electrically conductive nanoparticles (A) may be 50 mass% or less of a total amount (100 mass%) of the electrically conductive particles contained in the bonding conductive paste.

In the bonding conductive paste, the protective agent in the electrically conductive nanoparticles (A) contains as the amine:

an aliphatic hydrocarbon monoamine (1) composed of an aliphatic hydrocarbon group and one amino group, the aliphatic hydrocarbon group having 6 or more carbons in total; and may further contain
at least one of an aliphatic hydrocarbon monoamine (2) and an aliphatic hydrocarbon diamine (3), the aliphatic hydrocarbon monoamine (2) being composed of an aliphatic hydrocarbon group and one amino group, the aliphatic hydrocarbon group having 5 or less carbons in total, and the aliphatic hydrocarbon diamine (3) being composed of an aliphatic hydrocarbon group and two amino groups, the aliphatic hydrocarbon group having 8 or less carbons in total.

In the bonding conductive paste, the electrically conductive particles may contain, besides the electrically conductive nanoparticles (A), spherical electrically conductive particles (B) having an average particle size of 0.5 μm or more and 1 μm or less, and flat electrically conductive flakes (C) having an average particle size of 1 μm or more and 10 μm or less.

In the bonding conductive paste, a total content of the electrically conductive nanoparticles (A), the spherical electrically conductive particles (B), and the flat electrically conductive flakes (C) may be from 80 to 99.5 wt.% relative to a total amount (100 mass%) of the bonding conductive paste.

In the bonding conductive paste, the dispersion medium may contain an organic solvent (a), an organic solvent (b), and an organic solvent (c) which are mutually different compounds and satisfy Relations (1) to (6) described below:

$$150°C \leq Ta \leq 250°C \ (1)$$

$$150°C \leq Tb \leq 250°C \ (2)$$

$$250°C \leq Tc \leq 350°C \ (3)$$

$$\delta a \geq 10.0 \ (4)$$

$$\delta c \leq 9.0 \ (5)$$

$$\delta c \leq \delta b \leq \delta a \ (6)$$

[wherein Ta to Tc represent boiling points of the organic solvents (a) to (c), respectively, and δa to δc represent Hansen solubility parameters of the organic solvents (a) to (c), respectively].

The present disclosure also relates to a sintered body produced by sintering the bonding conductive paste.

The present disclosure also relates to a joint structure bonded with a sintered body produced by sintering the bonding conductive paste.

Advantageous Effects of Invention

The bonding conductive paste of the present disclosure can suppress solvent bleeding and can suppress void generation during sintered body formation. Thus, using the bonding conductive paste improves printing suitability in forming a sintered body such as a conductive wire or a joint structure for connecting electronic elements. The bonding conductive paste can suppress void generation, and thus can produce a sintered body such as a conductive wire or joint structure with high bonding strength, and an electronic device including such a sintered body.

Brief Description of Drawings

FIG. 1(a) is an SAT image of a sintered body surface after measurement of a die shear strength in a sample produced in Example 3, and FIG. 1(b) is an SAT image of a sintered body surface after measurement of a die shear strength in a sample produced in Comparative Example 2.
FIG. 2(a) is an SEM image of a sintered body cross section after measurement of a die shear strength in a sample produced in Example 3, and FIG. 2(b) is an SEM image of a sintered body cross section after measurement of a die shear strength in a sample produced in Comparative Example 2.

Description of Embodiments

[Bonding Conductive Paste]

A bonding conductive paste according to an embodiment of the present disclosure is a paste-like composition that can form a conductor capable of bonding members together. The bonding conductive paste is, for example, a bonding conductive paste for forming a sintered body (e.g., a conductive wire or a joint structure) for connecting electronic elements.

The bonding conductive paste contains electrically conductive particles, a dispersion medium containing a hydroxy group-containing ether-based solvent, and a urea compound. In the bonding conductive paste, the electrically conductive particles are dispersed in the dispersion medium.

(Electrically Conductive Particles)

The electrically conductive particles are fused by sintering the bonding conductive paste to form an electrically conductive sintered body. The electrically conductive substance constituting the electrically conductive particles is not particularly limited as long as it has electrical conductivity. For example, a metal, a metal oxide, a nonconductor having a metal-coated surface, or semiconductor particles can be used.

Examples of the metal constituting the electrically conductive particles include a metal having electrical conductivity, such as gold, silver, copper, nickel, aluminum, rhodium, cobalt, ruthenium, platinum, palladium, chromium, indium, and an alloy thereof. Examples of the metal oxide constituting the electrically conductive particles include a metal oxide having electrical conductivity, such as chromium oxide, nickel oxide, copper oxide, titanium oxide, zirconium oxide, indium oxide, aluminum oxide, zinc oxide, tin oxide, or composite oxides thereof, such as a composite oxide of indium oxide and tin oxide (ITO) and a composite oxide of tin oxide and phosphorus oxide (PTO). These electrically conductive substances can be used alone, or in combination of two or more types. The electrically conductive substance is more preferably a metal having excellent electrical conductivity, more preferably gold, silver, copper, or the like. Among them, silver is preferred from the viewpoint that silver particles are fused together at a temperature of approximately 100°C and can form an electrically conductive connection member for an electronic component with electrical conductivity or the like even on a general-purpose plastic substrate having low heat resistance. That is, the electrically conductive particles are preferably silver particles.

The electrically conductive particles preferably include electrically conductive nanoparticles (which may be referred to as "electrically conductive nanoparticles (A)" in the present specification) having an average particle size of 1 nm or more and less than 100 nm, and having a configuration in which the surfaces of the electrically conductive particles are coated with a protective agent containing an amine, more specifically, a configuration in which unshared electron pairs of the amine are electrically coordinated to the electrically conductive nanoparticle surfaces. Since the electrically conductive nanoparticles (A) have the above configuration, re-aggregation between the electrically conductive nanoparticles is prevented, and a highly dispersed state can be stably maintained in the bonding conductive paste. Only one type of the electrically conductive nanoparticles (A) may be used, or two or more types thereof may be used.

The electrically conductive nanoparticles (A) have an average particle size of 1 nm or more and less than 100 nm,

preferably 2 to 80 nm, more preferably 5 to 70 nm, and even more preferably 10 to 60 nm. The average particle size corresponds to a size excluding the protective agent covering the surface of each electrically conductive nanoparticle (i.e., the size of the electrically conductive nanoparticle itself). The average particle size is determined as an average particle size (median diameter) converted into a volume distribution on the assumption that the particles have an aspect ratio of 1, based on the particle size determined by observation with a transmission electron microscope (TEM). In the case of containing two or more types of electrically conductive nanoparticles (A), the average particle size refers to the average particle size of all the electrically conductive nanoparticles (A).

The electrically conductive nanoparticles (A) are surface-modified electrically conductive nanoparticles having a configuration in which the surfaces of the electrically conductive nanoparticles are coated with a protective agent containing an amine. Only one type of the aforementioned amine may be used, or two or more types thereof may be used. The protective agent may contain a compound other than the amine.

The amine is a compound in which at least one hydrogen atom of ammonia is substituted with a hydrocarbon group, and includes a primary amine, a secondary amine, and a tertiary amine. The amine may be a monoamine or a polyamine such as a diamine.

The amine preferably contains, among others, at least one selected from a monoamine (1) having 6 or more carbons in total and represented by Formula (a-1) below, wherein $R^1$, $R^2$, and $R^3$ are the same or different and are a hydrogen atom or a monovalent hydrocarbon group (excluding the case where $R^1$, $R^2$, and $R^3$ are all hydrogen atoms); a monoamine (2) having 5 or less carbons in total and represented by Formula (a-1) below, wherein $R^1$, $R^2$, and $R^3$ are the same or different and are a hydrogen atom or a monovalent hydrocarbon group (excluding the case where $R^1$, $R^2$, and $R^3$ are all hydrogen atoms); and a diamine (3) having 8 or less carbons in total and represented by Formula (a-2) below, wherein $R^8$ is a divalent hydrocarbon group, and $R^4$ to $R^7$ are the same or different and are a hydrogen atom or a monovalent hydrocarbon group; and in particular, the amine preferably contains the monoamine (1) in combination with the monoamine (2) and/or the diamine (3).

[Chem. 1]

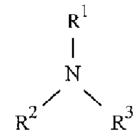

(a-1)

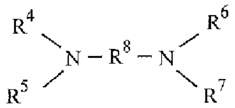

(a-2)

Examples of the hydrocarbon group include an aliphatic hydrocarbon group, an alicyclic hydrocarbon group, and an aromatic hydrocarbon group. Among them, an aliphatic hydrocarbon group or an alicyclic hydrocarbon group is preferred, and an aliphatic hydrocarbon group is particularly preferred. Thus, the monoamine (1), the monoamine (2), and the diamine (3) are preferably an aliphatic monoamine (1), an aliphatic monoamine (2), and an aliphatic diamine (3).

Examples of the monovalent aliphatic hydrocarbon group include an alkyl group and an alkenyl group. Examples of the monovalent alicyclic hydrocarbon group include a cycloalkyl group and a cycloalkenyl group. Examples of the divalent aliphatic hydrocarbon group include an alkylene group and an alkenylene group. Examples of the divalent alicyclic hydrocarbon group include a cycloalkylene group and a cycloalkenylene group.

Examples of the monovalent hydrocarbon group in $R^1$, $R^2$, and $R^3$ include alkyl groups having approximately from 1 to 20 carbons, such as a methyl group, an ethyl group, a propyl group, an isopropyl group, a butyl group, an isobutyl group, an s-butyl group, a t-butyl group, a pentyl group, a hexyl group, a decyl group, a dodecyl group, a tetradecyl group, and an octadecyl group; alkenyl groups having approximately from 2 to 20 carbons, such as a vinyl group, an allyl group, a methallyl group, a 1-propenyl group, an isopropenyl group, a 1-butenyl group, a 2-butenyl group, a 3-butenyl group, a 1-pentenyl group, a 2-pentenyl group, a 3-pentenyl group, a 4-pentenyl group, and a 5-hexenyl group; cycloalkyl groups having approximately from 3 to 20 carbons, such as a cyclopropyl group, a cyclobutyl group, a cyclopentyl group, a cyclohexyl group, and a cyclooctyl group; and cycloalkenyl groups having approximately from 3 to 20 carbons, such as a cyclopentenyl group and a cyclohexenyl group.

Examples of the monovalent hydrocarbon group in $R^4$ to $R^7$ include those having 7 or less carbons among those exemplified as the monovalent hydrocarbon group in $R^1$, $R^2$, and $R^3$.

Examples of the divalent hydrocarbon group in $R^8$ include alkylene groups having from 1 to 8 carbons, such as a methylene group, a methylmethylene group, a dimethylmethylene group, an ethylene group, a propylene group, a trimethylene group, a tetramethylene group, a pentamethylene group, and a heptamethylene group; and alkenylene

groups having from 2 to 8 carbons, such as a vinylene group, a propenylene group, a 1-butenylene group, a 2-butenylene group, a butadienylene group, a pentenylene group, a hexenylene group, a heptenylene group, and an octenylene group.

The hydrocarbon groups in the above $R^1$ to $R^8$ may have any type of substituent [e.g., a halogen atom, an oxo group, a hydroxy group, a substituted oxy group (e.g., a $C_{1-4}$ alkoxy group, a $C_{6-10}$ aryloxy group, a $C_{7-16}$ aralkyloxy group, or a $C_{1-4}$ acyloxy group), a carboxy group, a substituted oxycarbonyl group (e.g., a $C_{1-4}$ alkoxycarbonyl group, a $C_{6-10}$ aryloxycarbonyl group, or a $C_{7-16}$ aralkyloxycarbonyl group), a cyano group, a nitro group, a sulfo group, or a heterocyclic group]. The hydroxy group or the carboxy group may be protected by a protective group commonly used in the field of organic synthesis.

The monoamine (1) is a compound having a function of imparting high dispersibility to the electrically conductive nanoparticles (A). Examples of the monoamine (1) include primary amines having a linear alkyl group, such as hexylamine, heptylamine, octylamine, nonylamine, decylamine, undecylamine, dodecylamine, tridecylamine, tetradecylamine, pentadecylamine, hexadecylamine, heptadecylamine, and octadecylamine; primary amines having a branched alkyl group, such as isohexylamine, 2-ethylhexylamine, and tert-octylamine; primary amines having a cycloalkyl group, such as cyclohexylamine; primary amines having an alkenyl group, such as oleylamine; secondary amines having a linear alkyl group, such as N,N-dipropylamine, N,N-dibutylamine, N,N-dipentylamine, N,N-dihexylamine, N,N-dipeptylamine, N,N-dioctylamine, N,N-dinonylamine, N,N-didecylamine, N,N-diundecylamine, N,N-didodecylamine, and N-propyl-N-butylamine; secondary amines having a branched alkyl group, such as N,N-diisohexylamine and N,N-di(2-ethylhexyl)amine; tertiary amines having a linear alkyl group, such as tributylamine and trihexylamine; and tertiary amines having a branched alkyl group, such as triisohexylamine and tri(2-ethylhexyl)amine.

Among the monoamines (1), an amine (in particular, a primary amine) having a linear alkyl group having 6 or more carbons in total is preferred from the viewpoint that, when an amino group is adsorbed on the electrically conductive nanoparticle surface, the amino group can further provide sufficient spacing between the electrically conductive nanoparticle and another electrically conductive nanoparticle, thus improving the effect of preventing aggregation of the electrically conductive nanoparticles. The upper limit of the total number of carbons in the monoamine (1) is preferably approximately 18, more preferably 16, and particularly preferably 12, in view of easy availability and easy removal during sintering. In particular, the monoamine (1) is preferably hexylamine, heptylamine, octylamine, nonylamine, decylamine, undecylamine, dodecylamine, or the like.

Using an amine having a branched alkyl group (in particular, a primary amine) among the monoamines (1) can impart high dispersibility to the electrically conductive nanoparticles (A) with a smaller amount due to the steric factor of the branched alkyl group, as compared with the case of using an amine having a linear alkyl group having the same total number of carbons. Thus, the amine having a branched alkyl group is preferred from the viewpoint that the amine can be efficiently removed during sintering, particularly during low-temperature sintering, and a sintered body having more excellent electrical conductivity can be obtained.

The amine having a branched alkyl group is particularly preferably an amine having a branched alkyl group having from 6 to 16 (preferably from 6 to 10) carbons in total, such as isohexylamine or 2-ethylhexylamine, and in particular, from the viewpoint of the steric factor, an amine having a branched alkyl group having a structure in which the chain is branched at the second carbon from the nitrogen atom, such as 2-ethylhexylamine, is effective.

Among them, the monoamine (1) preferably includes an aliphatic hydrocarbon monoamine composed of an aliphatic hydrocarbon group and one amino group, the aliphatic hydrocarbon group having 6 or more carbons in total.

The monoamine (2) has a shorter hydrocarbon chain than the monoamine (1), and thus the monoamine (2) itself is considered to have a low function of imparting high dispersibility to the electrically conductive nanoparticles. However, the monoamine (2) has higher polarity than the monoamine (1) and has high coordination ability to the electrically conductive nanoparticles, and thus is considered to have an effect of promoting complex formation. In addition, the monoamine (2) has a short hydrocarbon chain and thus can be removed from the electrically conductive nanoparticle surfaces within a short time (e.g., 30 minutes or shorter, and preferably 20 minutes or shorter) even in low-temperature sintering, thus providing a sintered body with excellent electrical conductivity.

Examples of the monoamine (2) include primary amines having from 2 to 5 carbons in total and having a linear or branched alkyl group, such as ethylamine, n-propylamine, isopropylamine, n-butylamine, isobutylamine, sec-butylamine, tert-butylamine, pentylamine, isopentylamine, and tert-pentylamine; and secondary amines having from 2 to 5 carbons in total and having a linear or branched alkyl group, such as N-methyl-N-propylamine, N-ethyl-N-propylamine, N,N-dimethylamine, and N,N-diethylamine.

Among them, the monoamine (2) is preferably a primary amine having from 2 to 5 carbons in total (preferably from 4 to 5 carbons in total) and having a linear or branched alkyl group, such as n-butylamine, isobutylamine, sec-butylamine, tert-butylamine, pentylamine, isopentylamine, and tert-pentylamine, and in particular, preferably a primary amine having from 2 to 5 carbons in total (preferably from 4 to 5 carbons in total) and having a linear alkyl group, such as n-butylamine.

Among them, the monoamine (2) is preferably an aliphatic hydrocarbon monoamine (2) composed of an aliphatic hydrocarbon group and one amino group, the aliphatic hydrocarbon group having 5 or less carbons in total.

The diamine (3) has 8 or less (e.g., from 1 to 8) carbons in total and has higher polarity than the monoamine (1)

and has high coordination ability to the electrically conductive nanoparticles, and thus is considered to have an effect of promoting complex formation. In addition, the diamine (3) has an effect of promoting thermal decomposition of the complex at a lower temperature and in a short time in a thermal decomposition step of the complex, and using the diamine (3) enables more efficient production of the electrically conductive nanoparticles (A). Furthermore, the electrically conductive nanoparticles (A) having a configuration in which the surfaces are coated with the protective agent containing the diamine (3) exhibit excellent dispersion stability in a dispersion medium containing a highly polar solvent. Moreover, the diamine (3) has a short hydrocarbon chain and thus can be removed from the electrically conductive nanoparticle surfaces within a short time (e.g., 30 minutes or shorter, and preferably 20 minutes or shorter) even in low-temperature sintering, thus providing a sintered body with excellent electrical conductivity.

Examples of the diamine (3) include diamines of Formula (a-2) wherein $R^4$ to $R^7$ are a hydrogen atom, and $R^8$ is a linear or branched alkylene group, such as ethylenediamine, 1,3-propanediamine, 2,2-dimethyl-1,3-propanediamine, 1,4-butanediamine, 1,5-pentanediamine, 1,6-hexanediamine, 1,7-heptanediamine, 1,8-octanediamine, and 1,5-diamino-2-methylpentane; diamines of Formula (a-2) wherein $R^4$ and $R^6$ are the same or different and a linear or branched alkyl group, $R^5$ and $R^7$ are a hydrogen atom, and $R^8$ is a linear or branched alkylene group, such as N,N'-dimethylethylenediamine, N,N'-diethylethylenediamine, N,N'-dimethyl-1,3-propanediamine, N,N'-diethyl-1,3-propanediamine, N,N'-dimethyl-1,4-butanediamine, N,N'-diethyl-1,4-butanediamine, and N,N'-dimethyl-1,6-hexanediamine; and diamines of Formula (a-2) wherein $R^4$ and $R^5$ are the same or different and a linear or branched alkyl group, $R^6$ and $R^7$ are a hydrogen atom, and $R^8$ is a linear or branched alkylene group, such as N,N-dimethylethylenediamine, N,N-diethylethylenediamine, N,N-dimethyl-1,3-propanediamine, N,N-diethyl-1,3-propanediamine, N,N-dimethyl-1,4-butanediamine, N,N-diethyl-1,4-butanediamine, and N,N-dimethyl-1,6-hexanediamine.

Among these, the diamine (3) is preferably a diamine of Formula (a-2) wherein $R^4$ and $R^5$ are the same or different and a linear or branched alkyl group, $R^6$ and $R^7$ are a hydrogen atom, and $R^8$ is a linear or branched alkylene group [in particular, a diamine of Formula (a-2) wherein $R^4$ and $R^5$ are a linear alkyl group, $R^6$ and $R^7$ are a hydrogen atom, and $R^8$ is a linear alkylene group].

In the diamine of Formula (a-2) wherein $R^4$ and $R^5$ are the same or different and are a linear or branched alkyl group, and $R^6$ and $R^7$ are a hydrogen atom, that is, a diamine having a primary amino group and a tertiary amino group, the primary amino group has high coordination ability to a metal atom, but the tertiary amino group has a poor coordination ability to a metal atom. Thus, this prevents the complex to be formed from being excessively complicated, and thus the complex can be thermally decomposed at a lower temperature and in a shorter time in the thermal decomposition step of the complex. Among these, the diamine (3) is preferably a diamine having 6 or less (e.g., from 1 to 6) carbons in total and more preferably a diamine having 5 or less (e.g., from 1 to 5) carbons in total from the viewpoint that they can be removed from the electrically conductive nanoparticle surfaces within a short time in low-temperature sintering.

Among them, the diamine (3) is preferably an aliphatic hydrocarbon diamine (3) composed of an aliphatic hydrocarbon group and two amino groups, the aliphatic hydrocarbon group having 8 or less carbons in total.

In the amine containing the monoamine (1) in combination with the monoamine (2) and/or the diamine (3), the proportions of these amines used are not particularly limited, and are preferably in ranges described below based on the total amount of the amines [monoamine (1) + monoamine (2) + diamine (3); 100 mol%].

Content of monoamine (1): for example, from 5 to 65 mol% (The lower limit is preferably 10 mol%, and more preferably 15 mol%. The upper limit is preferably 50 mol%, more preferably 40 mol%, and even more preferably 35 mol%.)

Total content of monoamine (2) and diamine (3): for example, from 35 to 95 mol% (The lower limit is preferably 50 mol%, more preferably 60 mol%, and even more preferably 65 mol%. The upper limit is preferably 90 mol%, and more preferably 85 mol%.)

Furthermore, in the case of using the monoamine (2) and the diamine (3) together, the content of each of the monoamine (2) and the diamine (3) is preferably in a range described below based on the total amount of the amines [monoamine (1) + monoamine (2) + diamine (3); 100 mol%].

Monoamine (2): for example, from 5 to 70 mol% (The lower limit is preferably 10 mol%, and more preferably 15 mol%. The upper limit is preferably 65 mol%, and more preferably 60 mol%.)

Diamine (3): for example, from 5 to 50 mol% (The lower limit is preferably 10 mol%. The upper limit is preferably 45 mol%, and more preferably 40 mol%.)

When the content of the monoamine (1) is equal to or more than the lower limit described above, the dispersion stability of the electrically conductive nanoparticles is excellent, whereas when the content of the monoamine (1) is equal to or less than the upper limit described above, the amine tends to be easily removed by low-temperature sintering.

When the content of the monoamine (2) is within the above range the effect of promoting complex formation is easily obtained. In addition, sintering can be performed at a low temperature within a short time, and furthermore the diamine (3) is easily removed from the electrically conductive nanoparticle surfaces during sintering.

When the content of the diamine (3) is within the above range, the effect of promoting complex formation and the

effect of promoting thermal decomposition of the complex are easily obtained. In addition, the surface-modified electrically conductive nanoparticles (A) having a configuration in which the surfaces are coated with the protective agent containing the diamine (3) exhibit excellent dispersion stability in a dispersion medium containing a highly polar solvent.

When the monoamine (2) and/or the diamine (3) having high coordination ability to the electrically conductive nanoparticles is used in the bonding conductive paste, the amount of the monoamine (1) to be used can be reduced in accordance with the proportion of the monoamine (2) and/or the diamine (3) used, and, in the case of sintering at a low temperature for a short time, these amines are easily removed from the electrically conductive nanoparticle surfaces, and the sintering of the electrically conductive nanoparticles can be allowed to proceed sufficiently.

The amine used as the organic protective agent may contain an additional amine besides the monoamine (1), the monoamine (2), and the diamine (3). The proportion of the total content of the monoamine (1), the monoamine (2), and the diamine (3) in all the amines contained in the protective agent is, for example, preferably 60 mass% or more (e.g., from 60 to 100 mass%), more preferably 80 mass% or more, and even more preferably 90 mass% or more. That is, the content of the additional amine is preferably 40 mass% or less, more preferably 20 mass% or less, and even more preferably 10 mass% or less.

The amount of the amine [in particular, monoamine (1) + monoamine (2) + diamine (3)] to be used is not particularly limited, but is preferably approximately from 1 to 50 mol relative to 1 mol of an electrically conductive substance as a raw material for the electrically conductive nanoparticles. From the viewpoint that the surface-modified electrically conductive nanoparticles (A) can be produced substantially in the absence of a solvent, the amount of the amine used is preferably from 2 to 50 mol, and particularly preferably from 6 to 50 mol. When the amount of the amine used is equal to or more than the lower limit described above, an electrically conductive substance that is not converted into a complex is less likely to remain in the complex production step, and, in the subsequent thermal decomposition step, the uniformity of the electrically conductive nanoparticles is increased, thereby making it possible to suppress enlargement of the particles and remaining of the electrically conductive substance that is not thermally decomposed.

The protective agent may contain an additional protective agent besides the amine. Examples of the additional protective agent include an aliphatic monocarboxylic acid. Using an aliphatic monocarboxylic acid tends to further improve the dispersibility of the electrically conductive nanoparticles (A).

Examples of the aliphatic monocarboxylic acid include saturated aliphatic monocarboxylic acids having 4 or more carbons, such as butanoic acid, pentanoic acid, hexanoic acid, heptanoic acid, octanoic acid, nonanoic acid, decanoic acid, undecanoic acid, dodecanoic acid, tridecanoic acid, tetradecanoic acid, pentadecanoic acid, hexadecanoic acid, heptadecanoic acid, octadecanoic acid, nonadecanoic acid, and icosanoic acid; and unsaturated aliphatic monocarboxylic acids having 8 or more carbons, such as oleic acid, elaidic acid, linoleic acid, palmitoleic acid, and eicosenoic acid.

Among these, a saturated or unsaturated aliphatic monocarboxylic acid having from 8 to 18 carbons (in particular, octanoic acid or oleic acid) is preferred. When the carboxy group of the aliphatic monocarboxylic acid is adsorbed on the surface of an electrically conductive nanoparticle, the saturated or unsaturated aliphatic hydrocarbon chain having from 8 to 18 carbons causes a steric hindrance and thus can provide a space between the electrically conductive nanoparticle and another electrically conductive nanoparticle and improves the effect of preventing aggregation of the electrically conductive nanoparticles. **In** addition, the aliphatic monocarboxylic acid is preferred because it is easily available and easily removed during sintering.

The amount of the aliphatic monocarboxylic acid to be used is, for example, approximately from 0.05 to 10 mol, preferably from 0.1 to 5 mol, and more preferably from 0.5 to 2 mol, relative to 1 mol of an electrically conductive substance constituting the electrically conductive nanoparticles. When the amount of the aliphatic monocarboxylic acid to be used is equal to or more than the lower limit described above, the effect of improving stability is more easily obtained. When the amount of the aliphatic monocarboxylic acid to be used is equal to or less than the upper limit described above, the effect of the aliphatic monocarboxylic acid is sufficiently achieved, and excess aliphatic monocarboxylic acid is unlikely to remain.

The electrically conductive nanoparticles (A) having surfaces coated with the protective agent containing an amine can be produced by a known or commonly used method. For example, the electrically conductive nanoparticles (A) can be produced through a step of mixing a compound containing an electrically conductive substance with a protective agent containing an amine to produce a complex containing the compound and the amine (complex production step); a step of thermally decomposing the complex (thermal decomposition step); and, as necessary, a step of washing the reaction product (washing step).

The bonding conductive paste may contain additional electrically conductive particles besides the electrically conductive nanoparticles (A). The bonding conductive paste are preferably used, among others, in combination with electrically conductive particles (groups) having different average particle sizes in terms of being able to form a conductive wire or joint structure having a further lower electrical resistance and excellent electrical properties.

Examples of the shape of the additional electrically conductive particles include a spherical shape, a flat shape, and a polyhedral shape. Electrically conductive particles having different shapes may be used in combination, or only electrically conductive particles having the same shape may be used.

The additional electrically conductive nanoparticles are particularly preferably spherical electrically conductive particles (B) having an average particle size of 0.5 to 1 μm or flat electrically conductive flakes (C) having an average particle size of 1 to 10 μm.

(Spherical Electrically Conductive Particles (B))

When the spherical electrically conductive particles (B) having a larger size than the electrically conductive nanoparticles (A) are contained in combination with the electrically conductive nanoparticles (A), gaps between the spherical electrically conductive particles (B) having a relatively large size are filled with the electrically conductive nanoparticles (A) having a relatively small size in a sintered body to be formed. Thus, denser conductive wire and joint structure can be formed, and can be provided with high bonding strength and high electrical conductivity. Only one type of spherical electrically conductive particles (B) may be used, or two or more types thereof may be used.

The spherical electrically conductive nanoparticles (B) may be surface-modified electrically conductive particles having a configuration in which the surfaces of the electrically conductive particles are coated with a protective agent. In the surface-modified electrically conductive particles, spacing between the electrically conductive particles is secured, and aggregation is suppressed. Thus, the surface-modified electrically conductive particles exhibit excellent dispersibility in an organic solvent.

Examples of the electrically conductive substance constituting the spherical electrically conductive particles (B) include a metal having electrical conductivity, a metal oxide, a nonconductor having a metal-coated surface, and semiconductor particles, and include, for example, those exemplified and described as the metal and metal oxide constituting the electrically conductive nanoparticles (A) described above. In particular, the spherical electrically conductive particles (B) preferably contain the same electrically conductive substance as that contained in the electrically conductive nanoparticles (A) from the viewpoint of further increasing the bonding strength, and the electrically conductive substance is more preferably silver particles.

The protective agent is not particularly limited, and examples include known or commonly used protective agents used as a protective agent (stabilizer) for electrically conductive particles. Examples of the protective agent include protective agents having a functional group, such as a carboxy group, a hydroxy group, a carbonyl group, an amide group, an ether group, an amino group, a sulfo group, a sulfonyl group, a sulfinate group, a sulfenate group, a mercapto group, a phosphate group, or a phosphite group. Only one type of the protective agents may be used, or two or more types thereof may be used.

The spherical electrically conductive particles (B) have an average particle size (median diameter) of 0.5 to 1 μm and preferably 0.6 to 0.9 μm. The average particle size can be measured by a laser diffraction/scattering method. In the case where two or more types of spherical electrically conductive particles (B) are contained, the average particle size refers to the average particle size of all the spherical electrically conductive particles (B).

(Flat Electrically Conductive Flakes (C))

When the flat electrically conductive flakes (C) are contained in combination with the electrically conductive nanoparticles (A), necking between the electrically conductive particles is thickened in association with sintering of the flat electrically conductive flakes (C) themselves, and a stronger sintered body can be produced. Only one type of flat electrically conductive flakes (C) may be used, or two or more types thereof may be used.

The flat electrically conductive flakes (C) may be surface-modified electrically conductive flakes having a configuration in which the surfaces of the electrically conductive flakes are coated with a protective agent. The surface-modified electrically conductive flakes have sufficient spacing between the electrically conductive flakes. This prevents aggregation and provides the surface-modified electrically conductive flakes with excellent dispersibility in an organic solvent.

Examples of the electrically conductive substance constituting the flat electrically conductive flakes (C) include a metal having electrical conductivity, a metal oxide, a nonconductor having a metal-coated surface, and semiconductor flat particles, and include, for example, those exemplified and described as the electrically conductive substance constituting the electrically conductive nanoparticles (A) described above. In particular, the flat electrically conductive flakes (C) preferably contain the same electrically conductive substance (metal) as that contained in the electrically conductive nanoparticles (A) from the viewpoint of further increasing the bonding strength, and the electrically conductive substance is more preferably silver particles.

The protective agent is not particularly limited, and examples include known or commonly used organic protective agents used as a protective agent (stabilizer) for electrically conductive particles. Examples of the protective agent include organic protective agents having a functional group, such as a carboxy group, a hydroxy group, a carbonyl group, an amide group, an ether group, an amino group, a sulfo group, a sulfonyl group, a sulfinate group, a sulfenate group, a mercapto group, a phosphate group, or a phosphite group. Only one type of the protective agents may be used, or

two or more types thereof may be used.

The flat electrically conductive flakes (C) have an average particle size (median diameter) of 1 to 10 μm and preferably of 2 to 5 μm. The average particle size can be measured by a laser diffraction/scattering method. In the case where two or more types of flat electrically conductive flakes (C) are contained, the average particle size refers to the average particle size of all the flat electrically conductive flakes (C).

The content of the electrically conductive nanoparticles (A) is preferably 5 mass% or more and more preferably 10 mass% or more relative to 100 mass% of the electrically conductive particles contained in the bonding conductive paste. When the content is 5 mass% or more, a denser conductive wire or joint structure can be formed. The content is preferably 50 mass% or less, more preferably 30 mass% or less, and even more preferably 20 mass% or less. When the content is 50 mass% or less, the spherical electrically conductive particles (B) and the flat electrically conductive flakes (C) can be blended in sufficient amounts.

The content of the spherical electrically conductive particles (B) is preferably 30 mass% or more, more preferably 40 mass% or more, and even more preferably more than 50 mass% relative to 100 mass% of the electrically conductive particles contained in the bonding conductive paste. When the content is 30 mass% or more, the effect of blending the spherical electrically conductive particles (B) is more easily achieved. The content is preferably 85 mass% or less, more preferably 80 mass% or less, and even more preferably 70 mass% or less. When the content is 85 mass% or less, the electrically conductive nanoparticles (A) and the flat electrically conductive flakes (C) can be blended in sufficient amounts.

The content of the flat electrically conductive flakes (C) is preferably 10 mass% or more and more preferably 15 mass% or more relative to 100 mass% of the electrically conductive particles contained in the bonding conductive paste. When the content is 10 mass% or more, the effect of blending the flat electrically conductive flakes (C) is more easily achieved. The content is preferably 65 mass% or less, more preferably 50 mass% or less, and even more preferably 40 mass% or less. When the content is 65 mass% or less, the electrically conductive nanoparticles (A) and the spherical electrically conductive particles (B) can be blended in sufficient amounts.

The total content of the electrically conductive nanoparticles (A), the spherical electrically conductive particles (B), and the flat electrically conductive flakes (C) is preferably 70 mass% or more, more preferably 80 mass% or more, even more preferably 90 mass% or more, and particularly preferably 95 mass% or more relative to 100 mass% of the total amount of the electrically conductive particles contained in the bonding conductive paste. When the total content is 70 mass% or more, the electrically conductive particles exhibit more excellent dispersibility, continuous discharge stability, and storage stability. The total content may be 99.5 mass% or less and preferably 99 mass% or less.

(Dispersion Medium)

The dispersion medium contains a hydroxy group-containing ether-based solvent. The "hydroxy group-containing ether-based solvent" may be any compound that has one or more (e.g., one or two, and preferably one) hydroxy groups and an ether bond in the molecule and can be used as a solvent. The bonding conductive paste according to an embodiment of the present disclosure contains a hydroxy group-containing ether-based solvent as a dispersion medium. Thus, the electrically conductive particles exhibit excellent dispersion stability, and the bonding conductive paste can be provided with volatility suitable for printing.

The boiling point (at 1 atm) of the hydroxy group-containing ether-based solvent is preferably 130°C or higher (e.g., from 130 to 300°C), more preferably from 140 to 280°C, even more preferably from 150 to 260°C, and particularly preferably from 160 to 240°C.

The hydroxy group-containing ether-based solvent preferably has a vapor pressure of, for example, 0.01 to 10.0 mmHg at 30°C in terms of having appropriate volatility. The vapor pressure is more preferably 0.05 to 8.0 mmHg, even more preferably 0.1 to 6.0 mmHg, and most preferably of 0.3 to 4.0 mmHg.

The viscosity of the hydroxy group-containing ether-based solvent at 25°C and a shear rate of 10 $s^{-1}$ is preferably from 0.1 to 20 mPa·s, more preferably from 0.5 to 10 mPa·s, even more preferably from 1 to 9 mPa·s, and particularly preferably from 3 to 8 mPa·s in terms of providing an ink with a viscosity suitable for printing.

The hydroxy group-containing ether-based solvent is preferably, for example, a compound ((poly)alkylene glycol monoalkyl ether) represented by Formula (A) described below:

$$R^a\text{-}(O\text{-}R^b)_n\text{-}OH \qquad (A)$$

(wherein $R^a$ represents an alkyl group, an aryl group, or an aralkyl group; $R^d$ represents an alkylene group having from 1 to 6 carbons; and n represents an integer of 1 or more).

Examples of the alkyl group of $R^a$ in Formula (A) include linear or branched alkyl groups having from 1 to 10 (preferably from 1 to 5) carbons. Examples of the aryl group include aryl groups having from 6 to 10 carbons (e.g., a phenyl group). Examples of the aralkyl group include groups prepared by substituting a linear or branched alkyl group having from 1 to 10 (preferably from 1 to 5) carbons with an aryl group having from 6 to 10 carbons (e.g., a benzyl group).

Examples of the alkylene group of $R^d$ in Formula (A) include a methylene group, a methylmethylene group, a dimethylmethylene group, an ethylene group, a propylene group, a trimethylene group, a tetramethylene group, a pentamethylene group, and a hexamethylene group. Among them, the alkylene group is preferably an alkylene group having from 1 to 4 carbons, particularly preferably an alkylene group having from 1 to 3 carbons, and most preferably an alkylene group having from 2 to 3 carbons.

In Formula (A), n is an integer of 1 or more, for example, an integer of 1 to 8, preferably an integer of 1 to 3, and particularly preferably an integer of 2 or 3.

The boiling point of the compound represented by Formula (A) is, for example, 130°C or higher (e.g., from 130 to 310°C), preferably 170°C or higher, and particularly preferably 200°C or higher.

Examples of the compound represented by Formula (A) include ethylene glycol monomethyl ether (boiling point: 124°C), ethylene glycol monoisopropyl ether (boiling point: 141.8°C), ethylene glycol monobutyl ether (boiling point: 171.2°C), ethylene glycol monoisobutyl ether (boiling point: 160.5°C), ethylene glycol monohexyl ether (boiling point: 208°C), ethylene glycol mono-2-ethyl hexyl ether (boiling point: 229°C), ethylene glycol monophenyl ether (boiling point: 244.7°C), ethylene glycol monobenzyl ether (boiling point: 256°C), diethylene glycol monomethyl ether (boiling point: 194°C), diethylene glycol monobutyl ether (= butyl carbitol, boiling point: 230°C), diethylene glycol monoisobutyl ether (boiling point: 220°C), diethylene glycol monoisopropyl ether (boiling point: 207°C), diethylene glycol monopentyl ether (boiling point: 162°C), diethylene glycol monoisopentyl ether, diethylene glycol monohexyl ether (= hexyl carbitol, boiling point: 259.1°C), diethylene glycol mono-2-ethyl hexyl ether (boiling point: 272°C), diethylene glycol monophenyl ether (boiling point: 283°C), diethylene glycol monobenzyl ether (boiling point: 302°C), triethylene glycol monomethyl ether (boiling point: 249°C), triethylene glycol monobutyl ether (boiling point: 271.2°C), dipropylene glycol monoethyl ether (boiling point: 188°C), dipropylene glycol-n-propyl ether (boiling point: 212°C), dipropylene glycol-n-butyl ether (boiling point: 229°C), and tripropylene glycol methyl ether (boiling point: 242°C). One type of these solvents may be used alone, or two or more types thereof may be used in combination.

The dispersion medium may contain an ether-based solvent other than the hydroxy group-containing ether-based solvent, an ester-based solvent (e.g., (poly)alkylene glycol dialkyl ether, (poly)alkylene glycol monoalkyl ether monoester, (poly)alkylene glycol diester, or (poly)alkylene glycol monoester), a terpene-based solvent, an alcohol-based solvent (excluding the hydroxy group-containing ether-based solvent), a urea-based solvent, an aprotic polar solvent, a ketone-based solvent, an amine-based solvent, an alkane-based solvent, or the like.

The dispersion medium used in the present disclosure preferably contains an organic solvent (a), an organic solvent (b), and an organic solvent (c) from the viewpoint of excellent stability during continuous discharge and storage stability, and being able to suppress void generation during sintered body formation. The organic solvent (a), the organic solvent (b), and the organic solvent (c) are mutually different compounds and satisfy Relations (1) to (6) described below. Only one type of each of the organic solvent (a), the organic solvent (b), and the organic solvent (c) may be used, or two or more types thereof may be used.

$$150^\circ C \leq Ta \leq 250^\circ C \quad (1)$$

$$150^\circ C \leq Tb \leq 250^\circ C \quad (2)$$

$$250^\circ C \leq Tc \leq 350^\circ C \quad (3)$$

$$\delta a \geq 10.0 \quad (4)$$

$$\delta c \leq 9.0 \quad (5)$$

$$\delta c \leq \delta b \leq \delta a \quad (6)$$

In the relations, Ta to Tc represent the boiling points of the organic solvents (a) to (c), respectively, and δa to δc represent the Hansen solubility parameters of the organic solvents (a) to (c), respectively. In the present specification, the Hansen solubility parameter may be referred to as "SP value" and described as "δ".

The organic solvents (a) to (c) only need to be uniformly dissolved to form a liquid state when mixed at blending proportions used in the bonding conductive paste, and each of them may be in a liquid state or a solid state at room temperature by itself.

The organic solvent (a) satisfies at least Relation (1). That is, the boiling point Ta of the organic solvent (a) satisfies

150°C ≤ Ta ≤ 250°C, preferably satisfies 150°C < Ta < 250°C, more preferably satisfies 155°C ≤ Ta ≤ 220°C, and even more preferably satisfies 160°C ≤ Ta ≤ 200°C. When the organic solvent (a) having a boiling point within the above range is used, the dispersion medium is easily volatilized during sintering, and a sintered body can be easily formed.

The organic solvent (a) satisfies at least Relation (4) [$\delta a \geq 10.0$]. The SP value δa of the organic solvent (a) is 10.0 or more, preferably 10.3 or more, and more preferably 10.4 or more as long as the SP value δa satisfies Relation (6). When the δa is 10.0 or more, the electrically conductive nanoparticles (A) exhibit excellent dispersibility, and separation of the electrically conductive particles from the dispersion medium can be suppressed. The δa of the organic solvent (a) is, for example, 16.0 or less and may be 15.0 or less.

Examples of the organic solvent (a) include alcohol-based solvents, urea-based solvents, and aprotic polar solvents that satisfy Relations (1) and (4) above and satisfy Relation (6) in the relationship with the organic solvents (b) and (c). Examples of the **alcohol** solvent include compounds having one or more hydroxy groups. Among them, a tertiary alcohol or a hydroxy group-containing ether-based solvent is preferred. The alcohol-based solvent may have two or more hydroxy groups. Examples of the hydroxy group-containing ether-based solvent include (poly)alkylene glycol monoalkyl ethers and alkoxy group-substituted alcohols represented by Formula (A) above.

Specific examples of the organic solvent (a) include pinacol (δ 10.7, boiling point 172°C), tetramethylurea (δ 10.6, boiling point 177°C), 3-methoxybutanol (δ 10.6, boiling point 161°C), 1-methylcyclohexanol (δ 10.4, boiling point 155°C), and methyl carbitol (diethylene glycol monomethyl ether) (δ 10.7, boiling point 193°C).

The organic solvent (b) satisfies at least Relation (2). That is, the boiling point Tb of the organic solvent (b) satisfies 150°C ≤ Tb ≤ 250°C, preferably satisfies 150°C < Tb < 250°C, more preferably satisfies 180°C ≤ Tb ≤ 248°C, and even more preferably satisfies 200°C ≤ Tb ≤ 245°C. When the organic solvent (b) having a boiling point within the above range is used, the dispersion medium is easily volatilized during sintering and a sintered body can be easily formed. When the organic solvent (b) having a boiling point of 250°C or lower is used, void generation during sintering can be suppressed.

The organic solvent (b) satisfies at least Relation (6). The SP value δb of the organic solvent (b) is preferably from 8.0 to 12.0, more preferably from 8.5 to 11.0, and even more preferably from 9.0 to 10.5 as long as the SP value δb satisfies Relation (6). When the δb is within the above range, there is a tendency that the compatibility between the organic solvent (a) and the organic solvent (c) is improved, separation is less likely to occur, and continuous discharge stability and storage stability are more excellent.

Examples of the organic solvent (b) include alcohol-based solvents, ester-based solvents, ketone-based solvents, and amine-based solvents that satisfy Relation (2) and satisfy Relation (6) in the relationship with the organic solvents (a) and (c). Examples of the alcohol-based solvent include solvent compounds having one or more hydroxy groups. Among them, a tertiary alcohol, a hydroxy group-containing ether-based solvent, or an ester alcohol is preferred. Examples of the hydroxy group-containing ether-based solvent include (poly)alkylene glycol monoalkyl ethers and alkoxy group-substituted alcohols represented by Formula (A) above. The ester alcohol is a compound having an ester bond and a hydroxy group, and examples thereof include (poly)alkylene glycol monoalkyl ether monoesters. Examples of the ester-based solvent include diacetates of diols, such as (poly)alkylene glycols. The ketone-based solvent is preferably a cyclic ketone. The amine-based solvent is preferably an alkylamine.

The organic solvent (b) is selected on the premise that it satisfies Relation (6) in the relationship with the organic solvents (a) and (c). Specific examples of the organic solvent (b) that can be used include d-Camphor (camphor) (δ 10.4, boiling point 204°C), 1-heptanol (δ 10.0, boiling point 177°C), butyl carbitol (diethylene glycol monobutyl ether) (δ 10.2, boiling point 231°C), ethyl carbitol (diethylene glycol monoethyl ether) (δ 10.5, boiling point 196°C), tripropylene glycol monomethyl ether (δ 9.4, boiling point 243°C), α-terpineol (δ 9.3, boiling point 220°C), dihydroterpineol (δ 9.0, boiling point 210°C), 1,3-butanediol diacetate (δ 9.2, boiling point 232°C), propylene glycol diacetate (δ 9.3, boiling point 190°C), butyl carbitol acetate (δ 9.0, boiling point 247°C), dipropylene glycol butyl ether (δ 9.2, boiling point 230°C), isophorone (δ 9.5, boiling point 213°C), 1-decanol (δ 9.6, boiling point 230°C), propylene glycol monobutyl ether (δ 9.0, boiling point 170°C), and 1-nonanol (δ 9.8, boiling point 214°C).

Preferably, the boiling point Tb of the organic solvent (b) is higher than the boiling point Ta of the organic solvent (a), that is, Tb > Ta. The temperature difference between Tb and Ta [Tb - Ta] is preferably 2°C or more, more preferably 5°C or more, and even more preferably 10°C or more. When the temperature difference is 2°C or more, void generation during sintering can be further suppressed.

The organic solvent (c) satisfies at least Relation (3). That is, the boiling point Tc of the organic solvent (c) satisfies 250°C ≤ Tc ≤ 350°C, preferably satisfies 250°C < Tc < 350°C, more preferably satisfies 250°C < Tc ≤ 320°C, and even more preferably satisfies 250°C < Tc ≤ 300°C. When the organic solvent (c) having a boiling point within the above range is used, rapid volatilization of the organic solvent (a) and the organic solvent (b) and void generation can be suppressed during sintering.

The organic solvent (c) satisfies at least Relation (5) [$\delta c \leq 9.0$]. The SP value δc of the organic solvent (c) is 9.0 or less, preferably 8.7 or less, and more preferably 8.5 or less. When the δ is 9.0 or less, void generation during sintering can be suppressed. The δc of the organic solvent (c) is, for example, 6.0 or more and may be 7.0 or more.

Examples of the organic solvent (c) include ether-based solvents, alkane-based solvents, and ester-based

solvents that satisfy Relations (3) and (5) above and satisfy Relation (6) in the relationship with the organic solvents (a) and (b). Examples of the ether-based solvent include (poly)alkylene glycol dialkyl ethers. The alkane-based solvent is preferably an alkane having 14 or more carbons (e.g., from 14 to 20 carbons). Examples of the ester-based solvent include esters of (poly)alkylene glycol alkyl ethers and fatty acids.

Specific examples of the organic solvent (c) include dibutyl carbitol (diethylene glycol dibutyl ether) ($\delta$ 8.3, boiling point 255°C), tetradecane ($\delta$ 7.9, boiling point 254°C), and hexadecane ($\delta$ 8.0, boiling point 287°C).

Preferably. the boiling point Tc of the organic solvent (c) is higher than the boiling point Tb of the organic solvent (b), that is, Tc > Tb. The temperature difference between Tc and Tb [Tc - Tb] is preferably 2°C or more, more preferably 6°C or more, and even more preferably 10°C or more. When the temperature difference is 2°C or more, void generation during sintering can be further suppressed.

Preferably, the boiling point Tc of the organic solvent (c) is higher than the boiling point Ta of the organic solvent (a), that is, Tc > Ta. The temperature difference between Tc and Ta [Tc - Ta] is preferably 30°C or more, more preferably 50°C or more, and even more preferably 60°C or more. When the temperature difference is 30°C or more, void generation during sintering can be further suppressed.

The SP value $\delta a$ of the organic solvent (a), the SP value $\delta b$ of the organic solvent (b), and the SP value $\delta c$ of the organic solvent (c) satisfy Relation (6) above [$\delta c \leq \delta b \leq \delta a$]. In particular, preferably, $\delta b$ is preferably higher than $\delta c$, that is, $\delta c < \delta b$ is satisfied. In addition, preferably, $\delta a$ is higher than $\delta b$, that is, $\delta b < \delta a$ is satisfied.

The difference between $\delta b$ and $\delta c$ [$\delta b - \delta c$] is preferably 0.1 or more, more preferably 0.2 or more, and even more preferably 0.5 or more. When the difference is 0.1 or more, the electrically conductive particles exhibit more excellent dispersibility, and continuous discharge stability is more excellent. The difference is preferably 2.0 or less, more preferably 1.5 or less, and even more preferably 1.3 or less. When the difference is 2.0 or less, the electrically conductive particles and the dispersion medium are less likely to be separated, and continuous discharge stability and storage stability are more excellent.

The difference between $\delta a$ and $\delta b$ [$\delta a - \delta b$] is preferably 0.1 or more, more preferably 0.2 or more, and even more preferably 0.5 or more. When the difference is 0.1 or more, the electrically conductive particles exhibit more excellent dispersibility, and continuous discharge stability is more excellent. The difference is preferably 2.5 or less, more preferably 2.0 or less, and even more preferably 1.8 or less. When the difference is 2.5 or less, the electrically conductive particles and the dispersion medium are less likely to be separated, and continuous discharge stability and storage stability are more excellent.

The difference between $\delta a$ and $\delta c$ [$\delta a - \delta c$] based on Relations (4) and (5) is 1.0 or more, preferably 1.5 or more, and more preferably 2.0 or more. When the difference is 1.0 or more, void generation during sintering can be further suppressed. The difference is preferably 5.0 or less, more preferably 4.0 or less, and even more preferably 3.0 or less. When the difference is 5.0 or less, the electrically conductive particles and the dispersion medium are less likely to be separated, and continuous discharge stability and storage stability are more excellent.

The proportion of the organic solvent (a) relative to 100 mass% of the total amount of the organic solvent (a), the organic solvent (b), and the organic solvent (c) [organic solvent (a)/{ organic solvent (a) + organic solvent (b) + organic solvent (c)}] is preferably from 5 to 70 mass%, more preferably from 10 to 60 mass%, and even more preferably from 15 to 50 mass%. When the proportion is within the above range, the dispersion medium is easily volatilized during sintering, a sintered body can be easily formed, and the dispersibility of the metal particles is more excellent.

The proportion of the organic solvent (b) relative to 100 mass% of the total amount of the organic solvent (a), the organic solvent (b), and the organic solvent (c) [organic solvent (b)/{organic solvent (a) + organic solvent (b) + organic solvent (c)}] is preferably from 5 to 70 mass%, more preferably from 10 to 60 mass%, and even more preferably from 15 to 50 mass%. When the proportion is within the above range, the compatibility among the organic solvents is excellent, and continuous discharge stability and storage stability are more excellent.

The proportion of the organic solvent (c) relative to 100 mass% of the total amount of the organic solvent (a), the organic solvent (b), and the organic solvent (c) [organic solvent (c)/{ organic solvent (a) + organic solvent (b) + organic solvent (c)}] is preferably from 5 to 70 mass%, more preferably from 10 to 60 mass%, and even more preferably from 15 to 50 mass%. When the proportion is within the above range, void generation during sintering can be further suppressed.

The content of the organic solvent (c) relative to 100 parts by mass of the organic solvent (a) is preferably from 20 to 400 parts by mass, more preferably from 30 to 300 parts by mass, and even more preferably from 50 to 200 parts by mass. When the content is within the above range, the blending amounts of the organic solvent (a) and the organic solvent (c) are well balanced, and void suppression during sintering and the dispersibility of the metal particles are further improved.

The content of the organic solvent (b) relative to 100 parts by mass of the total amount of the organic solvent (a) and the organic solvent (c) is preferably from 10 to 200 parts by mass, more preferably from 20 to 150 parts by mass, and even more preferably from 40 to 100 parts by mass. When the content is within the above range, the compatibility between the organic solvent (a) and the organic solvent (c) is further improved, and continuous discharge stability and low-temperature storage property are more excellent.

The dispersion medium may contain an additional solvent (organic solvent) besides the organic solvent (a), the organic solvent (b), and the organic solvent (c). The total content of the organic solvent (a), the organic solvent (b), and the organic solvent (c) in the dispersion medium is preferably 50 mass% or more, more preferably 70 mass% or more, even more preferably 80 mass% or more, still more preferably 90 mass% or more, and particularly preferably 95 mass% or more, relative to 100 mass% of the total amount of the dispersion medium. When the total content is 50 mass% or more, the dispersibility of the electrically conductive particles and the compatibility among the organic solvents are more excellent, and continuous discharge stability, storage stability, and void formation suppression during sintering are more excellent.

When the organic solvent (a), the organic solvent (b), and the organic solvent (c) are mixed in blending proportions used in the bonding conductive paste, it is preferable that the organic solvent (a), the organic solvent (b), and the organic solvent (c) are homogeneously dissolved at ordinary temperature and do not cause phase separation. **In** the bonding conductive paste, it is preferable that the organic solvent (a), the organic solvent (b), and the organic solvent (c) are homogeneously dissolved at ordinary temperature and do not cause phase separation. **In** particular, the organic solvents preferably do not cause phase separation at 22 to 28°C (preferably at 10 to 30°C and more preferably at 0 to 35°C).

From the viewpoint of the dispersion stability of the electrically conductive particles and the volatility of the dispersion medium during sintering, the content of the hydroxy group-containing ether-based solvent is preferably from 10 to 60 mass%, more preferably from 15 to 55 mass%, and even more preferably from 25 to 45 mass% relative to the total amount (100 mass%) of the dispersion medium. The content of the hydroxy group-containing ether-based solvent relative to 100 mass% of the total of the organic solvent (a), the organic solvent (b), and the organic solvent (c) in the bonding conductive paste is preferably within the above range. **In** a preferred embodiment, the dispersion medium is composed only of the hydroxy group-containing ether-based solvent (100 mass%).

The content of the hydroxy group-containing ether-based solvent is preferably from 1 to 15 parts by mass, more preferably from 1.5 to 12 parts by mass, and even more preferably from 2 to 10 parts by mass, relative to 100 parts by mass of the electrically conductive particles. When the content is within the above range, the dispersion stability of the electrically conductive particles and volatility during sintering are excellent.

The content of the dispersion medium is preferably from 4 to 20 parts by mass, more preferably from 5 to 15 parts by mass, and even more preferably from 6 to 12 parts by mass, relative to 100 parts by mass of the electrically conductive particles. When the content is within the above range, the dispersion stability of the electrically conductive particles and volatility during sintering are excellent.

The total content of the organic solvent (a), the organic solvent (b), and the organic solvent (c) relative to 100 parts by mass of the electrically conductive particles is preferably within the above range.

(Urea Compound)

The bonding conductive paste according to an embodiment of the present disclosure contains a urea compound as an essential component. Since the bonding conductive paste according to an embodiment of the present disclosure contains a urea compound, the bonding conductive paste can suppress solvent bleeding, and can improve printing suitability in forming a sintered body, such as a conductive wire or a joint structure for connecting electronic elements. In addition, the bonding conductive paste containing a urea compound can suppress void generation during sintered body formation, and can produce a sintered body, such as a conductive wire or joint structure with high bonding strength, and an electronic device including them.

The urea compound is preferably a rheology control agent having a urea group (urea-based rheology control agent). Examples of the urea compound include modified urea compounds, such as a modified urea, a urea-modified urethane, and a polymeric urea derivative; and urea-modified polyamides, such as a urea-modified medium-polarity polyamide and a urea-modified low-polarity polyamide. The urea compound is considered to form a three-dimensional network structure by the hydrogen bonding force and the association effect due to the strong polarity of the urea group in the bonding conductive paste containing the hydroxy group-containing ether-based solvent in which the electrically conductive particles are dispersed. Conceivably, the formation of the three-dimensional structure causes an appropriate increase in viscosity, resulting in suppression of solvent bleeding, prevention of solvent bumping, and suppression of void generation. From the viewpoint of more efficient suppression of solvent bleeding and void generation, the urea compound is preferably a modified urea, a urea-modified urethane, or a urea-modified polyamide. These urea compounds may be used alone, or in combination of two or more types.

Examples of the modified urea include a compound in which copolymerization or a substituent is introduced into a main chain having one or more urea groups. Examples of the urea-modified urethane include a compound in which a part of a main chain having one or more urea groups is a urethane chain. Examples of the urea-modified polyamide include a compound in which a part of a main chain having one or more urea groups is an amide chain.

Examples of the polymeric urea derivative include urea derivatives having one or more urea groups and having a number average molecular weight of 1000 to 70000 in terms of polystyrene measured by a GPC method. In particular, the

polymeric urea derivative is preferably a compound having two or more urea groups and having a number average molecular weight of 3000 to 70000 in terms of polystyrene measured by a GPC method.

In consideration of facilitating stable formation of a three-dimensional network structure and improving the dispersibility, the urea compound is preferably mixed with a solvent in advance to form a mixture. In further consideration of these, the solvent is preferably selected from among a pyrrolidone derivative, a polyalkylene glycol, an aliphatic alcohol, an aromatic alcohol, a glycol ether, and a hydrocarbon-based solvent, more preferably selected from among a pyrrolidone derivative, a polyalkylene glycol, an amide ether, and an amide ester, and is most preferably a pyrrolidone derivative.

When a specific solvent is used as a main solvent for each of the aforementioned urea compounds, the urea compound is likely to form a three-dimensional network structure in a stable manner, and the dispersibility is easily improved.

Thus, in the case of using a modified urea, a pyrrolidone derivative is preferably used in view of improving the dispersibility. Examples of the pyrrolidone derivative include N-methylpyrrolidone, N-ethylpyrrolidone, N-vinylpyrrolidone, and 2-pyrrolidone. N-methylpyrrolidone is preferably used in view of further improving the dispersibility.

Similarly, in the case of using a urea-modified urethane, a polyalkylene glycol is preferably used. Examples of the polyalkylene glycol include polyethylene glycol and polypropylene glycol. Polypropylene glycol is preferably used in view of further improving the dispersibility.

Similarly, in the case of using a urea-modified polyamide, the solvent is preferably selected from among an aliphatic alcohol, a glycol ether, and a hydrocarbon-based solvent. Examples of the aliphatic alcohol include methanol, ethanol, 1-propanol, 2-propanol, isopropanol, isobutanol, and t-butanol. Examples of the glycol ether include ethylene glycol monophenyl ether (monophenyl glycol), propylene glycol monomethyl ether, propylene glycol monoethyl ether, diethylene glycol dimethyl ether, 3-methoxybutanol, and 3-methoxy-3-methylbutanol. Examples of the hydrocarbon-based solvent include benzene, toluene, xylene, solvent naphtha, octane, and mineral spirits. In view of further improving the dispersibility, the solvent is preferably selected from among isopropanol, isobutanol, ethylene glycol monophenyl ether (monophenyl glycol), propylene glycol monomethyl ether, solvent naphtha, and mineral spirits. In further view of the dispersibility, isopropanol, ethylene glycol monophenyl ether (monophenyl glycol), or solvent naphtha is preferably used.

The modified urea, the urea-modified urethane, or the urea-modified polyamide may be a commercially available product. Specific examples thereof include BYK-410 (main component: modified urea), BYK-411 (main component: modified urea), BYK-415 (main component: polymeric urea derivative), BYK-420 (main component: modified urea), BYK-425 (main component: urea-modified urethane), BYK-430 (main component: urea-modified medium-polarity polyamide), BYK-431 (main component: urea-modified low-polarity polyamide), and BYK-7420 (main component: modified urea), which are available from BYK Japan KK.

The content of the urea compound relative to 100 parts by mass of the hydroxy group-containing ether-based solvent is preferably from 3 to 50 parts by mass, more preferably from 3.5 to 30 parts by mass, and even more preferably from 4 to 20 parts by mass. When the content of the urea compound is 3 parts by mass or more, conceivably, a three-dimensional network structure is formed in the bonding conductive paste, resulting in an appropriate increase in viscosity, suppression of solvent bleeding, and an improvement in printing suitability. When the content of the urea compound is 50 parts by mass or less, conceivably, sintering inhibition caused by covering of the entire silver particles with the remaining urea compound is suppressed, and high bonding strength is exhibited. Thus, when the content of the urea compound is within the above range, solvent bleeding is suppressed, and printing suitability can be improved during formation of a sintered body, such as a conductive wire or a joint structure for connecting electronic elements. Furthermore, void generation is suppressed during sintered body formation, which can lead to production of a sintered body such as a conductive wire or joint structure having high bonding strength, and production of an electronic device including such a sintered body.

The content of the urea compound relative to 100 parts by mass of the entire dispersion medium containing the hydroxy group-containing ether-based solvent is preferably from 1 to 20 parts by mass, more preferably from 2 to 15 parts by mass, and even more preferably from 3 to 12 parts by mass. When the content of the urea compound is 1 part by mass or more, conceivably, a three-dimensional network structure is formed in the bonding conductive paste, resulting in an appropriate increase in viscosity, suppression of solvent bleeding, and an improvement in printing suitability. When the content of the urea compound is 20 parts by mass or less, conceivably, sintering inhibition caused by covering of the entire silver particles with the remaining urea compound is suppressed, and high bonding strength is exhibited. Thus, when the content of the urea compound is within the above range, solvent bleeding is suppressed, and printing suitability can be improved during formation of a sintered body, such as a conductive wire or a joint structure for connecting electronic elements. Furthermore, void generation is suppressed during sintered body formation, which can lead to production of a sintered body such as a conductive wire or joint structure having high bonding strength, and production of an electronic device including such a sintered body. The content of the urea compound relative to 100 parts by mass of the total of the organic solvent (a), the organic solvent (b), and the organic solvent (c) in the bonding conductive paste is preferably within the above range.

The content of the urea compound relative to 100 parts by mass of the electrically conductive particles is

preferably from 0.1 to 2 parts by mass, more preferably from 0.2 to 1.5 parts by mass, and even more preferably from 0.3 to 1.2 parts by mass. When the content of the urea compound is 0.1 parts by mass or more, conceivably, a three-dimensional network structure is formed in the bonding conductive paste, resulting in an appropriate increase in viscosity, suppression of solvent bleeding, and an improvement in printing suitability. When the content of the urea compound is 2 parts by mass or less, conceivably, sintering inhibition caused by covering of the entire silver particles with the remaining urea compound is suppressed, and high bonding strength is exhibited. Thus, when the content of the urea compound is within the above range, solvent bleeding is suppressed, and printing suitability can be improved during formation of a sintered body, such as a conductive wire or a joint structure for connecting electronic elements. Furthermore, void generation is suppressed during sintered body formation, which can lead to production of a sintered body such as a conductive wire or joint structure having high bonding strength, and production of an electronic device including such a sintered body. The content of the urea compound relative to 100 parts by mass of the total of the organic solvent (a), the organic solvent (b), and the organic solvent (c) in the bonding conductive paste is preferably within the above range.

The content of the urea compound relative to 100 parts by mass of the total of the electrically conductive particles and the dispersion medium is preferably from 0.09 to 1.8 parts by mass, more preferably from 0.15 to 1.4 parts by mass, and even more preferably from 0.25 to 1.1 parts by mass. When the content of the urea compound is 0.09 parts by mass or more, conceivably, a three-dimensional network structure is formed in the bonding conductive paste, resulting in an appropriate increase in viscosity, suppression of solvent bleeding, and an improvement in printing suitability. When the content of the urea compound is 1.8 parts by mass or less, conceivably, sintering inhibition caused by covering of the entire silver particles with the remaining urea compound is suppressed, and high bonding strength is exhibited. Thus, when the content of the urea compound is within the above range, solvent bleeding is suppressed, and printing suitability can be improved during formation of a sintered body, such as a conductive wire or a joint structure for connecting electronic elements. Furthermore, void generation is suppressed during sintered body formation, which can lead to production of a sintered body such as a conductive wire or joint structure having high bonding strength, and production of an electronic device including such a sintered body.

(Bonding Conductive Paste)

The content of the electrically conductive particles in the bonding conductive paste is preferably from 70 to 99.5 mass%, more preferably from 80 to 98 mass%, and even more preferably from 85 to 95 mass% relative to 100 mass% of the total amount of the bonding conductive paste. When the content is within the above range, the dispersibility of the electrically conductive particles is more excellent, and continuous discharge stability and storage stability are more excellent. The total content of the electrically conductive nanoparticles (A), the spherical electrically conductive particles (B), and the flat electrically conductive flakes (C) in the bonding conductive paste is preferably within the above range.

The content of the dispersion medium (in particular, the organic solvent) in the bonding conductive paste is preferably from 0.5 to 30 mass%, more preferably from 2 to 20 mass%, and even more preferably from 5 to 15 mass% relative to 100 mass% of the total amount of the bonding conductive paste. When the content is within the above range, the dispersibility of the electrically conductive particles is more excellent. The total content of the organic solvent (a), the organic solvent (b), and the organic solvent (c) in the bonding conductive paste is preferably within the above range.

The content of the hydroxy group-containing ether-based solvent in the bonding conductive paste is preferably from 0.5 to 15 mass%, more preferably from 1 to 13 mass%, and even more preferably from 2 to 12 mass% relative to 100 mass% of the total amount of the bonding conductive paste. When the content is within the above range, the dispersibility of the electrically conductive particles and volatility during sintering are more excellent.

The total content of the electrically conductive particles and the dispersion medium in the bonding conductive paste is preferably 70 mass% or more, more preferably from 80 mass% or more, even more preferably 90 mass% or more, and particularly preferably 95 mass% or more relative to 100 mass% of the total amount of the bonding conductive paste.

The content of the urea compound in the bonding conductive paste is preferably from 0.09 to 1.8 mass%, more preferably from 0.15 to 1.4 mass%, and even more preferably from 0.25 to 1.1 mass% relative to 100 mass% of the total amount of the bonding conductive paste. When the content of the urea compound is 0.09 mass% or more, conceivably, a three-dimensional network structure is formed in the bonding conductive paste, resulting in an appropriate increase in viscosity, suppression of solvent bleeding, and an improvement in printing suitability. When the content of the urea compound is 1.8 mass% or less, conceivably, sintering inhibition caused by covering of the entire silver particles with the remaining urea compound is suppressed, and high bonding strength is exhibited. Thus, when the content of the urea compound is within the above range, solvent bleeding is suppressed, and printing suitability can be improved during formation of a sintered body, such as a conductive wire or a joint structure for connecting electronic elements. Furthermore, void generation is suppressed during sintered body formation, which can lead to production of a sintered body such as a conductive wire or joint structure having high bonding strength, and production of an electronic device including such a sintered body.

The bonding conductive paste may contain an additional component besides the metal particles, the dispersion

medium, and the urea compound. The bonding conductive paste may contain, for example, an adhesive or an additive (e.g., a polymer compound having a molecular weight of 10000 or more, such as an epoxy resin, a silicone resin, or an acrylic resin). The content of such an adhesive or additive is, for example, 10 mass% or less, preferably 5 mass% or less, more preferably 3 mass% or less, and particularly preferably 1 mass% or less relative to 100 mass% of the total amount of the bonding conductive paste. Thus, the bonding conductive paste eliminates inhibition of the interactions between the electrically conductive particles or between the electrically conductive particles and a substrate caused by a non-electrically conductive component derived from a polymer compound, and can form a conductive wire or a joint structure having excellent electrical conductivity [an electrical resistance is, for example, $10 \times 10^{-6}\ \Omega\cdot cm$ or less, preferably $9.0 \times 10^{-6}\ \Omega\cdot cm$ or less, more preferably $8.5 \times 10^{-6}\ \Omega\cdot cm$ or less, and even more preferably $7.0 \times 10^{-6}\ \Omega\cdot cm$ or less].

The bonding conductive paste according to an embodiment of the present disclosure contains the urea compound as a rheology control agent. Thus, conceivably, a three-dimensional network structure is formed in the bonding conductive paste, and the viscosity is appropriately increased, resulting in suppression of solvent bleeding, promotion of the volatilization of the solvent, and suppression of void generation. Thus, solvent bleeding is suppressed, and printing suitability can be improved during formation of a sintered body, such as a conductive wire or a joint structure for connecting electronic elements. Furthermore, void generation is suppressed during sintered body formation, which can lead to production of a sintered body such as a conductive wire or joint structure having high bonding strength, and production of an electronic device including such a sintered body.

(Sintered Body)

The bonding conductive paste according to an embodiment of the present disclosure is applied to a substrate by a printing method (specifically, dispenser printing, mask printing, screen printing, inkjet printing, or the like), followed by sintering, to form a sintered body. Thus, a conductive wire or a joint structure can be formed. In particular, the bonding conductive paste is preferably printed by dispenser printing from the viewpoint of excellent continuous discharge stability.

The sintering temperature is, for example, 150°C or higher and lower than 300°C, and preferably from 170 to 250°C. The sintering time is, for example, from 0.1 to 2 hours and preferably from 0.5 to 1 hour.

The sintering may be performed in any of an air atmosphere, a nitrogen atmosphere, an argon atmosphere, and the like. Among them, the sintering is preferably performed in an air atmosphere from the viewpoint of economy and producing a conductive wire or joint structure having a lower electrical resistance.

The thickness of the bonding conductive paste applied onto a substrate is in a range such that the thickness of the conductive wire or the joint structure formed by the above method is, for example, 15 to 400 μm, preferably 20 to 250 μm, and more preferably 40 to 200 μm.

Examples of the substrate on which the conductive wire or the joint structure is formed include a ceramic substrate, a SiC substrate, a gallium nitride substrate, a metal substrate, a glass-epoxy substrate, a BT resin substrate, a glass substrate, and a resin substrate. The shape of the conductive wire or the joint structure is not particularly limited as long as it has a shape capable of connecting electronic elements.

The sintered body (e.g., a conductive wire or a joint structure) formed on a substrate using the bonding conductive paste can exhibit excellent bonding strength to the substrate, since the electrically conductive particles are densely aggregated and fused together by sintering. For example, when a silver-plated copper substrate and a silver-plated Si chip are bonded to each other, the bonding strength (in accordance with JIS Z3198) is preferably 30 MPa or more and more preferably 40 MPa or more.

The void rate measured using an ultrasonic imaging device (SAT) in a sintered body (e.g., a conductive wire or a joint structure) formed on a substrate using the bonding conductive paste is preferably 30% or less, more preferably 15% or less, and even more preferably less than 8%. When the void rate is 30% or less, the sintered body has higher bonding strength. A high void rate indicates the presence of many void spaces at a bonding interface or the like, which is considered to reduce the heat transfer area in a joint structure with a portion to be bonded. A decrease in heat transfer area is fatal in releasing heat during the operation of a semiconductor, and increases the possibility of generating a heat spot and leading to a failure. Specifically, the void rate can be measured by a method described in Examples.

The bonding conductive paste has the properties described above and thus can be preferably used, for example, for the purpose of producing an electronic component (e.g., a power semiconductor module or an LED module) using a printing method.

Each embodiment disclosed in the present specification can be combined with any other feature disclosed in the present specification. The configurations, combinations thereof, and the like in each embodiment are exemplary, and additions, omissions, replacements, and other changes of the configurations can be appropriately made without departing from the spirit of the present disclosure. In addition, each of the inventions according to the present disclosure is not limited by the embodiments or the following examples but is limited only by the claims.

Examples

An embodiment of the present disclosure will be described in more detail below based on Examples.

(Average Particle Size of Electrically Conductive Nanoparticles (A))

Hereinafter, the average particle size (median diameter) of the electrically conductive nanoparticles (A) was measured by the following method.

A suspension containing surface-modified silver nanoparticles produced in Preparation Example 1 was observed with a transmission electron microscope. The observation was performed at a magnification of 100000 times for four fields x 50. The observation was performed at a site where large and small particles coexisted. The number particle size distribution was determined by image analysis. This number particle size distribution was converted to a volume particle size distribution using a known conversion equation on the assumption that the aspect ratio of the particles was 1. The average particle size (median diameter) was determined from this particle size distribution and defined as the average particle size of the electrically conductive nanoparticles (A).

(Average Particle Sizes of Spherical Electrically Conductive Particles (B) and Flat Electrically Conductive flakes (C))

The average particle sizes are values measured by a laser diffraction/scattering method.

Metal particles, solvents, and urea compounds used are as follows.

[Metal Particles]

- Surface-modified silver nanoparticles (Preparation Example 1): average particle size (median diameter) 50 nm
- AG-2-8F: trade name "AG-2-8F", available from DOWA Electronics Materials Co., Ltd., spherical silver particles, average particle size (median diameter) 0.8 μm
- 41-104: trade name "41-104", available from Technic, flat silver flakes, average particle size (median diameter) 3.3 μm

[Solvent (I): high-polarity solvent]

- TMU: tetramethylurea, δ 10.6, boiling point 177°C, available from Daicel Corporation

[Solvent (II): medium-polarity solvent]

- TPM: tripropylene glycol monomethyl ether, δ 9.4, boiling point 243°C, available from Andoh Parachemie Co., Ltd.
- DHTP: dihydroterpineol, δ 9.0, boiling point 210°C, available from Yasuhara Chemical Co., Ltd.

[Solvent (III): low-polarity solvent]

- DBC: dibutyl carbitol, δ 8.3, boiling point 255°C, available from Tokyo Chemical Industry Co., Ltd.

[Urea Compounds]

- BYK-430: trade name "BYK-430", available from BYK Japan KK, main component: urea-modified medium-polarity polyamide
- BYK-420: trade name "BYK-420", available from BYK Japan KK, main component: modified urea

Preparation Example 1 (Preparation of Surface-Modified Silver Nanoparticles)

Silver oxalate (molecular weight: 303.78) was obtained from silver nitrate (available from Wako Pure Chemical Industries, Ltd.) and oxalic acid dihydrate (available from Wako Pure Chemical Industries, Ltd.).

To a 500-mL flask was added 40.0 g (0.1317 mol) of the silver oxalate, and 60 g of n-butanol was added thereto, to prepare a slurry of silver oxalate in n-butanol.

To the resulting slurry was added dropwise an amine mixture of 115.58 g (1.5802 mol) of n-butylamine (molecular weight: 73.14, reagent available from Tokyo Chemical Industry Co., Ltd.), 51.06 g (0.3950 mol) of 2-ethylhexylamine (molecular weight: 129.25, reagent available from Wako Pure Chemical Industries, Ltd.), and 17.02 g (0.1317 mol) of n-octylamine (molecular weight: 129.25, reagent available from Tokyo Chemical Industry Co., Ltd.) at 30°C.

After the dropwise addition, the mixture was stirred at 30°C for 1 hour to allow complex formation reaction between silver oxalate and the amines to proceed.

After the formation of a silver oxalate-amine complex, the silver oxalate-amine complex was thermally decomposed by heating at 110°C for 1 hour, to produce a dark blue suspension containing surface-modified silver nanoparticles.

The resulting suspension was cooled, 120 g of methanol (reagent available from Wako Pure Chemical Industries, Ltd., special grade) was added to the suspension, and the mixture was stirred. Then, the surface-modified silver nanoparticles were precipitated by centrifugation, and the supernatant was removed. Subsequently, 120 g of dibutyl carbitol was added, and the mixture was stirred. Then, the surface-modified silver nanoparticles were precipitated by centrifugation, and the supernatant was removed. Thus, wet surface-modified silver nanoparticles containing dibutyl carbitol were produced. From measurement results with a thermobalance using a TG/DTA 6300 available from SII, the content of the surface-modified silver nanoparticles was 81.6 wt.% in the total amount (100 wt.%) of the wet surface-modified silver nanoparticles. That is, the wet surface-modified silver nanoparticles contained 18.4 wt.% of dibutyl carbitol.

The wet surface-modified silver nanoparticles were observed using a scanning electron microscope (JSM-6700F, available from JEOL Ltd.), the particle sizes of 10 silver nanoparticles randomly selected in an SEM photograph were determined, and the average value was taken as the average particle size. The average particle size (primary particle size) of the silver nanoparticle portions in the surface-modified silver nanoparticles was 50 nm.

Example 1 (Preparation of Bonding Conductive Paste)

Trade name "41-104" (25.50 g), AG-2-8F (59.50 g), tetramethylurea (3.40 g), tripropylene glycol methyl ether (3.40 g), and BYK-420 (0.6 g) were added and mixed with a planetary centrifugal mixer (ARE-310, available from THINKY), to prepare a liquid A.

92.40 g of the liquid A was added and mixed with 18.40 g of the wet surface-modified silver nanoparticles (containing 18.4 mass% of dibutyl carbitol) produced in Preparation Example 1 by using a planetary centrifugal mixer (ARE-310, available from THINKY), to prepare a blackish gray bonding conductive paste (1).

Examples 2 to 6 and Comparative Examples 1 to 4

Bonding conductive pastes were produced in the same manner as in Example 1 except that the formulation was changed as shown in Table 1. The numerical value of each component shown in Table 1 represents "parts by mass".

<Evaluation>

The bonding conductive pastes produced in Examples and Comparative Examples were evaluated as follows. The results are shown in Table 1.

The following substrates and apparatus were used.

[Substrate]

- Silver-plated substrate (available from Nippon Testpanel Co., Ltd.)

  Substrate: copper (1.0 mm x 9 mm x 60 mm)
  Base: electroless nickel-plated (5 μm)
  Outermost surface: semigloss silver-plated (1.0 μm)

- Silicon chip (available from Yamanaka Hutech Corporation)

Silicon (0.525 mm x 3 mm x 3 mm)
Base: titanium 500 nm sputtered
Outermost surface: silver 2 μm sputtered

[Apparatus]

- Sintering furnace (reflow furnace)
RSS-450-210-FA (available from UNITEMP)

(1) Printing Evaluation

Each of the bonding conductive pastes produced in the Examples and Comparative Examples was printed on the substrate through a metal mask in which 3 x 3 openings each having a size of 5 x 5 mm were arranged at a space of 2.5 mm.

Printing suitability was evaluated according to the following criteria. The results are shown in Table 1.

- The shape of the bonding conductive paste printed in the openings of 5 x 5 mm is maintained on the silver-plated substrate, and the dispersion medium does not bleed from the paste: ∘ (good)
- The shape of the bonding conductive paste printed in the openings of 5 x 5 mm is deformed on the silver-plated substrate, or the dispersion medium bleeds from the paste: × (Poor)

(2) Die Shear Strength

Then, a substrate (2), which was the same as the substrate (1), was placed on the formed coating film, and heated and sintered using the reflow furnace without application of pressure under the following conditions, to prepare a sample (substrate (1)/sintered bonding conductive paste/substrate (2)).

- Under atmosphere:

From 25°C to 200°C (temperature rise rate: 5°C/min)
Held at 200°C for 60 min

For the resulting samples (n = 4), the bonding strength between the substrate (1) and the substrate (2) was measured using a die shear tester SERIES 4000 (available from DAGE) at room temperature under the following conditions to evaluate the bondability.

Table 1 shows the average bonding strength (MPa) in the case of using the silver-plated substrate and the silicon chip.

Test speed: 50 μm/s
Test height: 50 μm

(3) SAT Evaluation

For the sample produced in the evaluation of the die shear strength, the peeling state of the bonded interface was observed using an ultrasonic imaging device and a 25 MHz probe for reflection method. The image obtained through this observation was divided into 100 parts, and a white portion having a longitudinal length of 100 μm or more in each enlarged image was defined as a void. In each of the 100 divided images, the area of the white portions was determined as a void rate by image processing, and the average of the void rates in all the divided images was defined as a void rate. A sample having a void rate of less than 8% was evaluated as ∘, a sample having a void rate of 8% or more and less than 30% was evaluated as Δ, and a sample having a void rate of 30% or more was evaluated as ×.

FIG. 1(a) illustrates an SAT image of a sintered body surface after die shear strength measurement in a sample produced in Example 3, and FIG. 1(b) illustrates an SAT image of a sintered body surface after die shear strength measurement in a sample produced in Comparative Example 2. Generation of a void was not observed in Example 3, whereas generation of many voids was observed in Comparative Example 2.

(4) SEM Image Results

For the sample produced in the evaluation of the die shear strength, the center of the chip was cut and its cross section was polished using a milling device. Then, the bonded cross section was observed by adjusting the magnification using a scanning electron microscope.

FIG. 2(a) illustrates an SEM image of a sintered body cross section after die shear strength measurement in a sample produced in Example 3, and FIG. 2(b) illustrates an SEM image of a sintered body cross section after die shear strength measurement in a sample produced in Comparative Example 2. Generation of a void was not observed in Example 3, whereas generation of a void was observed in Comparative Example 2.

(5) Comprehensive Evaluation

A sample satisfying all of the following criteria was evaluated as ◦, and a sample not satisfying at least one of the following criteria was evaluated as ×.

- Printing evaluation was ◦
- Die shear strength was 30 MPa or more
- SAT evaluation was ◦

[Table 1]

Table 1

| Formulation | | Example 1 | Example 2 | Example 3 | Example 4 | Example 5 | Example 6 | Comparative Example 1 | Comparative Example 2 | Comparative Example 3 | Comparative Example 4 |
|---|---|---|---|---|---|---|---|---|---|---|---|
| Dispersion medium | TPM | 3.4 | 3.4 | 3.79 | 3.79 | 10 | 10 | 3.48 | | 2.8 | 3.57 |
| | TMU | 3.4 | 3.4 | | | | | 3.48 | | 2.8 | 3.57 |
| | DBC | 3.4 | 3.4 | | | | | 3.48 | 9.11 | 2.8 | 3.57 |
| | DHTP | | | 5.35 | 5.35 | | | | | | |
| Urea compound | BYK-420 | 0.6 | | 0.6 | | 0.6 | | | 0.6 | 2.4 | 0.09 |
| | BYK-430 | | 0.6 | | 0.6 | | 0.6 | | | | |
| | Total | 10.8 | 10.8 | 9.74 | 9.74 | 10.6 | 10.6 | 10.4 | 9.71 | 10.8 | 10.8 |
| Electrically conductive particles | Surface-modified silver nanoparticles | 15 | 15 | 15 | 15 | 15 | 15 | 15 | 15 | 15 | 15 |
| | AG-2-8F | 59.5 | 59.5 | 59.5 | 59.5 | 59.5 | 59.5 | 59.5 | 59.5 | 59.5 | 59.5 |
| | 41-104 | 25.5 | 25.5 | 25.5 | 25.5 | 25.5 | 25.5 | 25.5 | 25.5 | 25.5 | 25.5 |
| | Total | 100 | 100 | 100 | 100 | 100 | 100 | 100 | 100 | 100 | 100 |
| Comprehensive evaluation | | ○ | ○ | ○ | ○ | ○ | ○ | × | × | × | × |
| Printing evaluation | | ○ | ○ | ○ | ○ | ○ | ○ | × (bleeding) | × (chipping, bleeding) | × (chipping, bleeding) | × (chipping, bleeding) |
| SAT evaluation | | ○ | ○ | ○ | ○ | ○ | ○ | ○ | × | ○ | ○ |
| 3-mm Opening die shear strength [MPa] | | 65.2 | 62.7 | 57.4 | 55.1 | 46.2 | 43.8 | 73.4 | 70.6 | 0 (not sintered) | 70.7 |

As shown in Table 1, the bonding conductive pastes of the Examples containing electrically conductive particles and a dispersion medium containing tripropylene glycol monomethyl ether as a hydroxy group-containing ether-based solvent, and further containing a predetermined amount of a urea compound exhibited excellent printing suitability with no chipping or bleeding observed in the printing evaluation, and exhibited excellent bonding strength with suppressed void generation in the SAT evaluation.

In contrast, in Comparative Example 1 wherein no urea compound was contained, void generation was suppressed in the SAT evaluation, and excellent bonding strength was exhibited, but bleeding was observed in the printing evaluation.

In Comparative Example 2 wherein a predetermined amount of a urea compound was contained, but a hydroxy group-containing ether-based solvent was not contained as a dispersion medium, excellent bonding strength was exhibited, but chipping and bleeding were observed in the printing evaluation, and a void rate of 30% or more was determined.

In Comparative Example 3 wherein a urea compound was contained in an amount exceeding a predetermined amount, chipping and bleeding were observed in the printing evaluation, and the sample was not sintered in the die shear strength test. This was probably due to that the excessive urea compound covered the silver particles and inhibited sintering.

In Comparative Example 4 wherein a urea compound was contained in an amount less than a predetermined amount, void generation was suppressed in the SAT evaluation, and excellent bonding strength was exhibited, but bleeding was observed in the printing evaluation.

Hereinafter, variations of the invention according to the present disclosure will be described.

[Appendix 1] A bonding conductive paste containing electrically conductive particles, a dispersion medium containing a hydroxy group-containing ether-based solvent, and a urea compound, wherein
a content of the urea compound is from 1 to 20 parts by mass (preferably from 2 to 15 parts by mass and more preferably from 3 to 12 parts by mass) relative to 100 parts by mass of the entire dispersion medium containing the hydroxy group-containing ether-based solvent.

[Appendix 2] A bonding conductive paste containing electrically conductive particles, a dispersion medium containing a hydroxy group-containing ether-based solvent, and a urea compound, wherein
a content of the urea compound is from 0.1 to 2 parts by mass (preferably from 0.2 to 1.5 parts by mass and more preferably from 0.3 to 1.2 parts by mass) relative to 100 parts by mass of the electrically conductive particles.

[Appendix 3] The bonding conductive paste according to Appendix 1 or 2, wherein a content of the urea compound is from 3 to 50 parts by mass (preferably from 3.5 to 30 parts by mass and more preferably from 4 to 20 parts by mass) relative to 100 parts by mass of the hydroxy group-containing ether-based solvent.

[Appendix 4] The bonding conductive paste according to any one of Appendices 1 to 3, wherein a content of the urea compound is from 0.09 to 1.8 parts by mass (preferably from 0.15 to 1.4 parts by mass and more preferably from 0.25 to 1.1 parts by mass) relative to 100 parts by mass of a total of the electrically conductive particles and the dispersion medium.

[Appendix 5] The bonding conductive paste according to any one of Appendices 1 to 4, wherein a content of the urea compound is from 0.09 to 1.8 mass% (preferably from 0.15 to 1.4 mass% and more preferably from 0.25 to 1.1 mass%) relative to 100 mass% of a total amount of the bonding conductive paste.

[Appendix 6] The bonding conductive paste according to any one of Appendices 1 to 5, wherein the urea compound is at least one selected from the group consisting of a modified urea, a urea-modified urethane, a polymeric urea derivative, and a urea-modified polyamide (e.g., such as a urea-modified medium-polarity polyamide or a urea-modified low-polarity polyamide).

[Appendix 7] The bonding conductive paste according to any one of Appendices 1 to 6, wherein the electrically conductive particles contain silver particles.

[Appendix 8] The bonding conductive paste according to any one of Appendices 1 to 7, wherein

the electrically conductive particles contain electrically conductive nanoparticles (A) having an average particle size of 1 nm or more and less than 100 nm (preferably from 2 to 80 nm, more preferably from 5 to 70 nm, and even more preferably from 10 to 60 nm), and
the electrically conductive nanoparticles (A) are electrically conductive nanoparticles having a configuration in which surfaces of the electrically conductive nanoparticles are coated with a protective agent containing an amine.

[Appendix 9] The bonding conductive paste according to Appendix 8, wherein the protective agent in the electrically conductive nanoparticles (A) contains as the amine:

an aliphatic hydrocarbon monoamine (1) composed of an aliphatic hydrocarbon group and one amino group, the aliphatic hydrocarbon group having 6 or more carbons in total; and

at least one of an aliphatic hydrocarbon monoamine (2) and an aliphatic hydrocarbon diamine (3), the aliphatic hydrocarbon monoamine (2) being composed of an aliphatic hydrocarbon group and one amino group, the aliphatic hydrocarbon group having 5 or less carbons in total, and the aliphatic hydrocarbon diamine (3) being composed of an aliphatic hydrocarbon group and two amino groups, the aliphatic hydrocarbon group having 8 or less carbons in total.

[Appendix 10] The bonding conductive paste according to Appendix 9, wherein a content of each amine is in a range below based on a total amount of the amines [monoamine (1) + monoamine (2) + diamine (3); 100 mol%]:

content of the monoamine (1): from 5 to 65 mol% (the lower limit is preferably 10 mol% and more preferably 15 mol%, and the upper limit is preferably 50 mol%, more preferably 40 mol%, and even more preferably 35 mol%); and
total content of the monoamine (2) and the diamine (3): from 35 to 95 mol% (the lower limit is preferably 50 mol%, more preferably 60 mol%, and even more preferably 65 mol%, and the upper limit is preferably 90 mol% and more preferably 85 mol%).

[Appendix 11] The bonding conductive paste according to Appendix 9, wherein in the case of using the monoamine (2) and the diamine (3) together, each content of the monoamine (2) and the diamine (3) is in a range below based on a total amount of the amines [monoamine (1) + monoamine (2) + diamine (3); 100 mol%]:

the monoamine (2): from 5 to 70 mol% (the lower limit is preferably 10 mol% and more preferably 15 mol%, and the upper limit is preferably 65 mol% and more preferably 60 mol%); and
the diamine (3): from 5 to 50 mol% (the lower limit is preferably 10 mol%, and the upper limit is preferably 45 mol% and more preferably 40 mol%).

[Appendix 12] The bonding conductive paste according to any one of Appendices 8 to 11, wherein the electrically conductive particles contain spherical electrically conductive particles (B) with an average particle size of 0.5 μm or more and 1 μm or less (preferably from 0.6 to 0.9 μm) and flat electrically conductive flakes (C) with an average particle size of 1 μm or more and 10 μm or less (preferably from 2 to 5 μm) in addition to the electrically conductive nanoparticles (A).

[Appendix 13] The bonding conductive paste according to any one of Appendices 8 to 12, wherein a proportion of the electrically conductive nanoparticles (A) is 50 mass% or less (preferably 30 mass% or less and more preferably 20 mass% or less) of a total amount (100 mass%) of the electrically conductive particles contained in the bonding conductive paste.

[Appendix 14] The bonding conductive paste according to any one of Appendices 8 to 13, wherein a proportion of the electrically conductive nanoparticles (A) is 5 mass% or more (preferably 10 mass% or more) of a total amount (100 mass%) of the electrically conductive particles contained in the bonding conductive paste.

[Appendix 15] The bonding conductive paste according to any one of Appendices 12 to 14, wherein a content of the spherical electrically conductive particles (B) is 30 mass% or more (preferably 40 mass% or more and more preferably more than 50 mass% or more) and 85 mass% or less (preferably 80 mass% or less and more preferably 70 mass% or less) of a total amount (100 mass%) of the electrically conductive particles contained in the bonding conductive paste.

[Appendix 16] The bonding conductive paste according to any one of Appendices 12 to 15, wherein a content of the flat electrically conductive flakes (C) is 10 mass% or more (preferably 15 mass% or more) and 65 mass% or less (preferably 50 mass% or less and more preferably 40 mass% or less) of a total amount (100 mass%) of the electrically conductive particles contained in the bonding conductive paste.

[Appendix 17] The bonding conductive paste according to any one of Appendices 12 to 16, wherein a total content of the electrically conductive nanoparticles (A), the spherical electrically conductive particles (B), and the flat electrically conductive flakes (C) in a total amount (100 mass%) of the bonding conductive paste is 70 mass% or more (preferably 80 mass% or more, more preferably 90 mass% or more, and even more preferably 95 mass% or more) and 99.5 mass% or less (preferably 99 mass% or less).

[Appendix 18] The bonding conductive paste according to any one of Appendices 1 to 17, wherein the hydroxy group-containing ether-based solvent has a boiling point (at 1 atm) of 130°C or higher (e.g., from 130 to 300°C, preferably from 140 to 280°C, more preferably from 150 to 260°C, and even more preferably from 160 to 240°C).

[Appendix 19] The bonding conductive paste according to any one of Appendices 1 to 18, wherein the hydroxy group-containing ether-based solvent has a vapor pressure at 30°C of from 0.01 to 10.0 mmHg (preferably from 0.05 to 8.0 mmHg, more preferably from 0.1 to 6.0 mmHg, and even more preferably from 0.3 to 4.0 mmHg).

[Appendix 20] The bonding conductive paste according to any one of Appendices 1 to 19, wherein a viscosity of the hydroxy group-containing ether-based solvent at 25°C and a shear rate of 10 $s^{-1}$ is from 0.1 to 20 mPa·s (preferably from 0.5 to 10 mPa·s, more preferably from 1 to 9 mPa·s, and even more preferably from 3 to 8 mPa·s).

[Appendix 21] The bonding conductive paste according to any one of Appendices 1 to 20, wherein the hydroxy group-containing ether-based solvent contains a compound represented by Formula (A) described below:

$R^a$-O-($R^b$-O)$_n$-OH (A)

(wherein $R^a$ represents an alkyl group, an aryl group, or an aralkyl group; $R^d$ represents an alkylene group having from 1 to 6 carbons; and n represents an integer of 1 or more).

[Appendix 22] The bonding conductive paste according to Appendix 21, wherein the compound represented by Formula (A) above has a boiling point of 130°C or higher (e.g., from 130 to 310°C, preferably 170°C or higher, and more preferably 200°C or higher).

[Appendix 23] The bonding conductive paste according to any one of Appendices 1 to 22, wherein the dispersion medium contains an organic solvent (a), an organic solvent (b), and an organic solvent (c) which are mutually different compounds and satisfy Relations (1) to (6) described below:

$$150°C \leq Ta \leq 250°C \ (1)$$

$$150°C \leq Tb \leq 250°C \ (2)$$

$$250°C \leq Tc \leq 350°C \ (3)$$

$$\delta a \geq 10.0 \ (4)$$

$$\delta c \leq 9.0 \ (5)$$

$$\delta c \leq \delta b \leq \delta a \ (6)$$

[wherein Ta to Tc represent boiling points of the organic solvents (a) to (c), respectively, and δa to δc represent Hansen solubility parameters of the organic solvents (a) to (c), respectively].

[Appendix 24] The bonding conductive paste according to Appendix 23, wherein a boiling point Ta of the organic solvent (a) satisfies 150°C < Ta < 250°C (preferably 155°C ≤ Ta ≤ 220°C and more preferably 160°C ≤ Ta ≤ 200°C).

[Appendix 25] The bonding conductive paste according to Appendix 23 or 24, wherein an SP value δa of the organic solvent (a) is 10.3 or more (preferably 10.4 or more).

[Appendix 26] The bonding conductive paste according to any one of Appendices 23 to 25, wherein the SP value δa of the organic solvent (a) is 16.0 or less (or 15.0 or less).

[Appendix 27] The bonding conductive paste according to any one of Appendices 23 to 26, wherein a boiling point Tb of the organic solvent (b) satisfies 150°C < Tb < 250°C (preferably 180°C ≤ Tb ≤ 248°C and more preferably 200°C ≤ Tb ≤ 245°C).

[Appendix 28] The bonding conductive paste according to any one of Appendices 23 to 27, wherein an SP value δb of the organic solvent (b) is preferably from 8.0 to 12.0 (preferably from 8.5 to 11.0 and more preferably from 9.0 to 10.5).

[Appendix 29] The bonding conductive paste according to any one of Appendices 23 to 28, wherein a temperature difference between Tb and Ta [Tb - Ta] is preferably 2°C or more (preferably 5°C or more and more preferably 10°C or more).

[Appendix 30] The bonding conductive paste according to any one of Appendices 23 to 29, wherein a boiling point Tc of the organic solvent (c) satisfies 250°C < Tc < 350°C (preferably 250°C < Tc ≤ 320°C and more preferably 250°C < Tc ≤ 300°C).

[Appendix 31] The bonding conductive paste according to any one of Appendices 23 to 30, wherein an SP value δc of the organic solvent (c) is 8.7 or less (preferably 8.5 or less).

[Appendix 32] The bonding conductive paste according to any one of Appendices 23 to 31, wherein the SP value δc of the organic solvent (c) is 6.0 or more (or 7.0 or more).

[Appendix 33] The bonding conductive paste according to any one of Appendices 23 to 32, wherein a temperature difference between Tc and Tb [Tc - Tb] is preferably 2°C or more (preferably 6°C or more and more preferably 10°C or more).

[Appendix 34] The bonding conductive paste according to any one of Appendices 23 to 33, wherein a temperature difference between Tc and Ta [Tc - Ta] is preferably 30°C or more (preferably 50°C or more and more preferably 60°C or more).

[Appendix 35] The bonding conductive paste according to any one of Appendices 23 to 34, wherein δc < δb is

satisfied.

[Appendix 36] The bonding conductive paste according to any one of Appendices 23 to 35, wherein $\delta b < \delta a$ is satisfied.

[Appendix 37] The bonding conductive paste according to any one of Appendices 23 to 36, wherein a difference between $\delta b$ and $\delta c$ [$\delta b - \delta c$] is 0.1 or more (preferably 0.2 or more and more preferably 0.5 or more).

[Appendix 38] The bonding conductive paste according to any one of Appendices 23 to 37, wherein the difference between $\delta b$ and $\delta c$ [$\delta b - \delta c$] is 2.0 or less (preferably 1.5 or less and more preferably 1.3 or less).

[Appendix 39] The bonding conductive paste according to any one of Appendices 23 to 38, wherein a difference between $\delta a$ and $\delta b$ [$\delta a - \delta b$] is 0.1 or more (preferably 0.2 or more and more preferably 0.5 or more).

[Appendix 40] The bonding conductive paste according to any one of Appendices 23 to 39, wherein the difference between $\delta a$ and $\delta b$ [$\delta a - \delta b$] is 2.5 or less (preferably 2.0 or less and more preferably 1.8 or less).

[Appendix 41] The bonding conductive paste according to any one of Appendices 23 to 40, wherein a difference between $\delta a$ and $\delta c$ [$\delta a - \delta c$] is 1.5 or more (preferably 2.0 or more).

[Appendix 42] The bonding conductive paste according to any one of Appendices 23 to 41, wherein the difference between $\delta a$ and $\delta c$ [$\delta a - \delta c$] is 5.0 or less (preferably 4.0 or less and more preferably 3.0 or less).

[Appendix 43] The bonding conductive paste according to any one of Appendices 23 to 42, wherein a proportion of the organic solvent (a) to 100 mass% of a total amount of the organic solvent (a), the organic solvent (b), and the organic solvent (c) [organic solvent (a)/{ organic solvent (a) + organic solvent (b) + organic solvent (c)}] is preferably from 5 to 70 mass% (preferably from 10 to 60 mass% and more preferably from 15 to 50 mass%).

[Appendix 44] The bonding conductive paste according to any one of Appendices 23 to 43, wherein a proportion of the organic solvent (b) to 100 mass% of a total amount of the organic solvent (a), the organic solvent (b), and the organic solvent (c) [organic solvent (b)/{ organic solvent (a) + organic solvent (b) + organic solvent (c)}] is preferably from 5 to 70 mass% (preferably from 10 to 60 mass% and more preferably from 15 to 50 mass%).

[Appendix 45] The bonding conductive paste according to any one of Appendices 23 to 44, wherein a proportion of the organic solvent (c) to 100 mass% of a total amount of the organic solvent (a), the organic solvent (b), and the organic solvent (c) [organic solvent (c)/{ organic solvent (a) + organic solvent (b) + organic solvent (c)}] is preferably from 5 to 70 mass% (preferably from 10 to 60 mass% and more preferably from 15 to 50 mass%).

[Appendix 46] The bonding conductive paste according to any one of Appendices 23 to 45, wherein a content of the organic solvent (c) relative to 100 parts by mass of the organic solvent (a) is from 20 to 400 parts by mass (preferably from 30 to 300 parts by mass and more preferably from 50 to 200 parts by mass).

[Appendix 47] The bonding conductive paste according to any one of Appendices 23 to 46, wherein a content of the organic solvent (b) relative to 100 parts by mass of a total amount of the organic solvent (a) and the organic solvent (c) is from 10 to 200 parts by mass (preferably from 20 to 150 parts by mass and more preferably from 40 to 100 parts by mass).

[Appendix 48] The bonding conductive paste according to any one of Appendices 1 to 47, wherein a content of the hydroxy group-containing ether-based solvent relative to a total amount (100 mass%) of the dispersion medium is from 10 to 60 mass% (preferably from 15 to 55 mass% and more preferably from 25 to 45 mass%).

[Appendix 49] The bonding conductive paste according to any one of Appendices 1 to 47, wherein the dispersion medium is composed only of the hydroxy group-containing ether-based solvent.

[Appendix 50] The bonding conductive paste according to any one of Appendices 1 to 49, wherein a content of the hydroxy group-containing ether-based solvent relative to 100 parts by mass of the electrically conductive particles is from 1 to 15 parts by mass (preferably from 1.5 to 12 parts by mass and more preferably from 2 to 10 parts by mass).

[Appendix 51] The bonding conductive paste according to any one of Appendices 1 to 50, wherein a content of the dispersion medium relative to 100 parts by mass of the electrically conductive particles is from 4 to 20 parts by mass (preferably from 5 to 15 parts by mass and more preferably from 6 to 12 parts by mass).

[Appendix 52] The bonding conductive paste according to any one of Appendices 1 to 51, wherein a content of the electrically conductive particles relative to 100 mass% of a total amount of the bonding conductive paste is from 70 to 99.5 mass% (preferably from 80 to 98 mass% and more preferably from 85 to 95 mass%).

[Appendix 53] The bonding conductive paste according to any one of Appendices 1 to 52, wherein a content of the dispersion medium (in particular, the organic solvent) relative to 100 mass% of a total amount of the bonding conductive paste is from 0.5 to 30 mass% (preferably from 2 to 20 mass% and more preferably from 5 to 15 mass%).

[Appendix 54] The bonding conductive paste according to any one of Appendices 1 to 53, wherein a content of the hydroxy group-containing ether-based solvent relative to 100 mass% of a total amount of the bonding conductive paste is from 0.5 to 15 mass% (preferably from 1 to 13 mass% and more preferably from 2 to 12 mass%).

[Appendix 55] The bonding conductive paste according to any one of Appendices 1 to 54, wherein a total content of the dispersion medium relative to 100 mass% of a total amount of the bonding conductive paste is 70 mass% or more (preferably 80 mass% or more, more preferably 90 mass% or more, and even more preferably 95 mass% or more).

[Appendix 56] The bonding conductive paste according to any one of Appendices 1 to 55, wherein when a silver-plated copper substrate and a silver-plated Si chip are bonded together through a sintered body of the bonding conductive

paste, a bonding strength (in accordance with JIS Z3198) is 30 MPa or more (preferably 40 MPa or more).

[Appendix 57] The bonding conductive paste according to any one of Appendices 1 to 56, wherein a void rate in a sintered body of the bonding conductive paste as measured using an ultrasonic imaging device is 30% or less (preferably less than 8%).

[Appendix 58] A sintered body produced by sintering the bonding conductive paste described in any one of Appendices 1 to 57.

[Appendix 59] A joint structure bonded with a sintered body produced by sintering the bonding conductive paste described in any one of Appendices 1 to 57.

[Appendix 60] An electronic device including the sintered body described in Appendix 58.

Industrial Applicability

The bonding conductive paste according to the present disclosure is suitable for use in forming a conductive wire or a joint structure for connecting an electronic element, such as a power semiconductor element or an LED element.

## Claims

1. A bonding conductive paste comprising electrically conductive particles, a dispersion medium containing a hydroxy group-containing ether-based solvent, and a urea compound, wherein
a content of the urea compound is from 1 to 20 parts by mass relative to 100 parts by mass of the entire dispersion medium containing the hydroxy group-containing ether-based solvent.

2. A bonding conductive paste comprising electrically conductive particles, a dispersion medium containing a hydroxy group-containing ether-based solvent, and a urea compound, wherein
a content of the urea compound is from 0.1 to 2 parts by mass relative to 100 parts by mass of the electrically conductive particles.

3. The bonding conductive paste according to claim 1 or 2, wherein the hydroxy group-containing ether-based solvent contains a compound represented by Formula (A):

$$R^a\text{-O-}(R^b\text{-O})_n\text{-OH} \qquad (A)$$

wherein $R^a$ represents an alkyl group, an aryl group, or an aralkyl group; $R^d$ represents an alkylene group having from 1 to 6 carbons; and n represents an integer of 1 or more.

4. The bonding conductive paste according to claim 1 or 2, wherein the urea compound is at least one selected from the group consisting of a modified urea, a urea-modified urethane, a polymeric urea derivative, and a urea-modified polyamide.

5. The bonding conductive paste according to claim 1 or 2, wherein the electrically conductive particles contain silver particles.

6. The bonding conductive paste according to claim 1 or 2, wherein

   the electrically conductive particles contain electrically conductive nanoparticles (A) having an average particle size of 1 nm or more and less than 100 nm, and
   the electrically conductive nanoparticles (A) are electrically conductive nanoparticles having a configuration in which surfaces of the electrically conductive nanoparticles are coated with a protective agent containing an amine.

7. The bonding conductive paste according to claim 6, wherein a proportion of the electrically conductive nanoparticles (A) is 50 mass% or less relative to a total amount (100 mass%) of the electrically conductive particles contained in the bonding conductive paste.

8. The bonding conductive paste according to claim 6, wherein the protective agent in the electrically conductive nanoparticles (A) contains as the amine:

an aliphatic hydrocarbon monoamine (1) containing an aliphatic hydrocarbon group and one amino group, the aliphatic hydrocarbon group having 6 or more carbons in total; and
at least one of an aliphatic hydrocarbon monoamine (2) and an aliphatic hydrocarbon diamine (3), the aliphatic hydrocarbon monoamine (2) containing an aliphatic hydrocarbon group and one amino group, the aliphatic hydrocarbon group having 5 or less carbons in total, and the aliphatic hydrocarbon diamine (3) containing an aliphatic hydrocarbon group and two amino groups, the aliphatic hydrocarbon group having 8 or less carbons in total.

**9.** The bonding conductive paste according to claim 6, wherein the electrically conductive particles contain, besides the electrically conductive nanoparticles (A), spherical electrically conductive particles (B) having an average particle size of 0.5 μm or more and 1 μm or less, and flat electrically conductive flakes (C) having an average particle size of 1 μm or more and 10 μm or less.

**10.** The bonding conductive paste according to claim 9, wherein a total content of the electrically conductive nanoparticles (A), the spherical electrically conductive particles (B), and the flat electrically conductive flakes (C) is from 80 to 99.5 mass% relative to a total amount (100 mass%) of the bonding conductive paste.

**11.** The bonding conductive paste according to claim 1 or 2, wherein the dispersion medium contains an organic solvent (a), an organic solvent (b), and an organic solvent (c) which are mutually different compounds and satisfy Relations (1) to (6):

$$150°C \leq Ta \leq 250°C \ (1)$$

$$150°C \leq Tb \leq 250°C \ (2)$$

$$250°C \leq Tc \leq 350°C \ (3)$$

$$\delta a \geq 10.0 \ (4)$$

$$\delta c \leq 9.0 \ (5)$$

$$\delta c \leq \delta b \leq \delta a \ (6)$$

wherein Ta to Tc represent boiling points of the organic solvents (a) to (c), respectively, and δa to δc represent Hansen solubility parameters of the organic solvents (a) to (c), respectively.

**12.** A sintered body produced by sintering the bonding conductive paste described in claim 1 or 2.

**13.** A joint structure bonded with a sintered body produced by sintering the bonding conductive paste described in claim 1 or 2.

**14.** An electronic device comprising the sintered body described in claim 12.

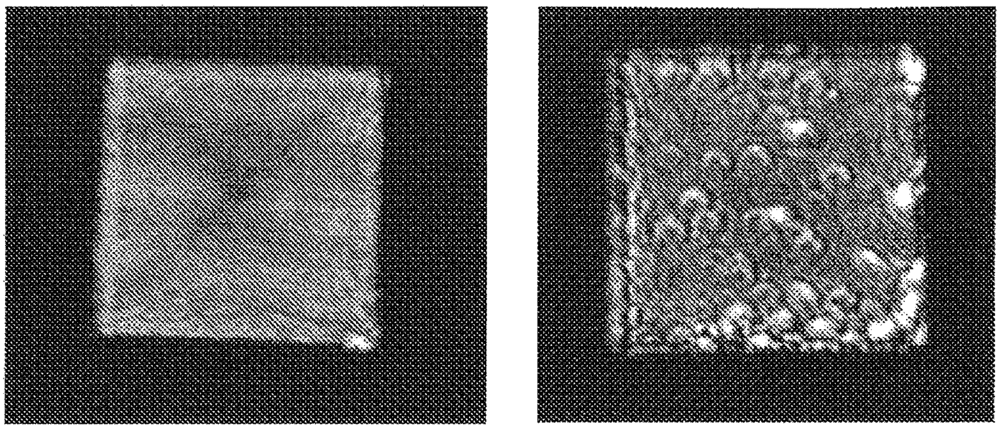

(a) (b)

FIG. 1

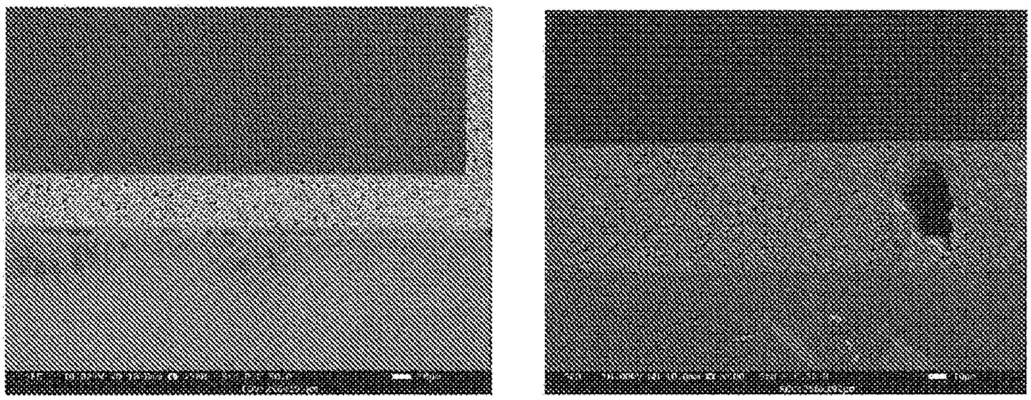

(a) (b)

FIG. 2

**INTERNATIONAL SEARCH REPORT**

International application No.
**PCT/JP2023/032896**

**A. CLASSIFICATION OF SUBJECT MATTER**

***H01B 1/22***(2006.01)i; ***B22F 1/00***(2022.01)i; ***B22F 1/052***(2022.01)i; ***B22F 1/054***(2022.01)i; ***B22F 1/065***(2022.01)i; ***B22F 1/068***(2022.01)i; ***B22F 1/102***(2022.01)i; ***B22F 1/107***(2022.01)i; ***B22F 7/08***(2006.01)i; ***B82Y 30/00***(2011.01)i; ***H01B 1/00***(2006.01)i; ***H05K 3/32***(2006.01)i

FI: H01B1/22 A; B22F1/00 K; B22F1/052; B22F1/054; B22F1/065; B22F1/068; B22F1/102; B22F1/107; B22F7/08 C; B82Y30/00; H01B1/00 E; H01B1/00 H; H01B1/00 K; H01B1/00 L; H05K3/32 B

According to International Patent Classification (IPC) or to both national classification and IPC

**B. FIELDS SEARCHED**

Minimum documentation searched (classification system followed by classification symbols)

H01B1/22; B22F1/00; B22F1/052; B22F1/054; B22F1/065; B22F1/068; B22F1/102; B22F1/107; B22F7/08; B82Y30/00; H01B1/00; H05K3/32

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2005-276573 A (TAIYO INK MFG CO., LTD.) 06 October 2005 (2005-10-06) paragraphs [0010]-[0037] | 1-5, 12 |
| Y | | 6-7, 9-10, 13-14 |
| A | | 8, 11 |
| Y | WO 2017/038572 A1 (HARIMA CHEMICALS INC.) 09 March 2017 (2017-03-09) paragraphs [0036], [0041], [0045], [0046] | 6-7, 9-10, 13-14 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **08 November 2023** | **21 November 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2023/032896**

| Patent document cited in search report | Publication date (day/month/year) | Patent family member(s) | Publication date (day/month/year) |
|---|---|---|---|
| JP 2005-276573 A | 06 October 2005 | (Family: none) | |
| WO 2017/038572 A1 | 09 March 2017 | TW 201719677 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2022146294 A
- JP 2020194786 A